# EUROPEAN PATENT APPLICATION

(11) **EP 4 582 760 A2**
(43) Date of publication of application: **09.07.2025**
(21) Application number: 25150261.3
(22) Date of filing: 03.01.2025
(51) Int. Cl.: F28D 15/02, H01L 23/427, H04M 1/02, H04M 1/72

(54) **DISPLAY DEVICE**

(30) Priority: 04.01.2024 KR 20240001238
(71) Applicant: Samsung Display Co., Ltd., Yongin-si, Gyeonggi-do 17113 (KR)
(72) Inventor: KIM, SUNGHOON, 17113 Yongin-si (KR); KIM, SEUNGHO, 17113 Yongin-si (KR); PARK, HAENGWON, 17113 Yongin-si (KR); BAE, HYUNCHUL, 17113 Yongin-si (KR); SON, JUNHEE, 17113 Yongin-si (KR); HWANG, SANGHO, 17113 Yongin-si (KR)
(74) Representative: Taor, Simon Edward William

(57) **Abstract**

A display device includes a display module including a lower surface defined by first and second directions and an upper surface displaying an image and a pulsating heat pipe on the lower surface of the display module. The pulsating heat pipe includes a first heat exchanger including first pipes arranged in the first direction, second pipes connecting the first pipes most adjacent to each other among the first pipes, and a first fluid filled in the first and second pipes and existing in a liquid or gaseous state and a second heat exchanger spaced apart from the first heat exchanger in the second direction and including third pipes arranged in the first direction, fourth pipes connecting the third pipes most adjacent to each other among the third pipes, and a second fluid filled in the third and fourth pipes and existing in a liquid or gaseous state.

## Description

### CROSS-REFERENCE TO RELATED APPLICATION

The present application claims priority to and the benefit of Korean Patent Application No. 10-2024-0001238, filed on January 4, 2024, in the Korean Intellectual Property Office.

### BACKGROUND

### 1. Field

Aspects of some embodiments of the present disclosure relate to a display device.

### 2. Description of Related Art

A display device, such as a smartphone, a digital camera, a notebook computer, a navigation unit, a smart television, etc., displays images through a display screen thereof. The display device includes a display panel that generates the images.

Various display devices are becoming significantly more advanced with the progression of technology, and electronic components built into them are becoming larger in capacity and highly integrated. Accordingly, a lot of heat is generated in the electronic components of the display device. The heat generated in the display device may shorten the life of products or causes component failure or malfunction. Methods to dissipate the heat generated in the display device to the outside are being studied.

The above information disclosed in this Background section is only for enhancement of understanding of the background and therefore the information discussed in this Background section does not necessarily constitute prior art.

### SUMMARY

Aspects of some embodiments of the present disclosure relate to a display device. For example, aspects of some embodiments of the present disclosure relate to a display device with a relatively improved heat dissipation function.

Aspects of some embodiments of the present disclosure include a display device that may be capable of preventing or reducing defects caused by heat from occurring in a display panel.

Aspects of some embodiments of the present disclosure include a display device including a display module including a lower surface defined by a first direction and a second direction intersecting the first direction and an upper surface opposite to the lower surface and displaying an image and a pulsating heat pipe on the lower surface of the display module. According to some embodiments, the pulsating heat pipe includes a first heat exchanger including a plurality of first pipes arranged in the first direction, a plurality of second pipes connecting the first pipes most adjacent to each other among the first pipes, and a first fluid filled in the first pipes and the second pipes and existing in a liquid state or a gaseous state and a second heat exchanger spaced apart from the first heat exchanger in the second direction and including a plurality of third pipes arranged in the first direction, a plurality of fourth pipes connecting the third pipes most adjacent to each other among the third pipes, and a second fluid filled in the third pipes and the fourth pipes and existing in a liquid state or a gaseous state. According to some embodiments, each of the first and second heat exchangers includes a first area, a second area, and a third area, which have different temperatures from each other, a first ratio, which is defined as a ratio of the first fluid in the gaseous state to the first fluid in the liquid state, is different in each of the first, second, and third areas of the first heat exchanger, and a second ratio, which is defined as a ratio of the second fluid in the gaseous state to the second fluid in the liquid state, is different in each of the first, second, and third areas of the second heat exchanger.

According to some embodiments, the first pipes are linearly symmetrical with the third pipes based on the first direction.

According to some embodiments, the pulsating heat pipe further includes a third heat exchanger between the first heat exchanger and the second heat exchanger, and the third heat exchanger further includes a plurality of fifth pipes arranged in the first direction and a plurality of sixth pipes connecting the fifth pipes most adjacent to each other among the fifth pipes.

According to some embodiments, the pulsating heat pipe further includes a connection pipe that connects pipes of two heat exchangers among the first, second, and third heat exchangers.

According to some embodiments, a length in the second direction of the first heat exchanger is greater than about 0% and equal to or smaller than about 20% of a total length in the second direction of the pulsating heat pipe, and a length in the first direction of the second heat exchanger is greater than about 0% and equal to or smaller than about 20% of the total length in the second direction of the pulsating heat pipe.

According to some embodiments, the number of the first pipes is at least five.

According to some embodiments, a length in the first direction of the pulsating heat pipe is equal to or greater than about 400 mm, and a length in the second direction of the pulsating heat pipe is equal to or greater than about 100 mm.

According to some embodiments, a filling rate of the first fluid in the first heat exchanger is equal to or greater than about 35% and equal to or smaller than about 80%.

According to some embodiments, the first fluid and the second fluid include the same material.

According to some embodiments, the first area is spaced apart from the third area with the second area interposed therebetween, the third area is insulated, the second area has a temperature greater than a temperature of the first area, and the third area has a temperature lower than a temperature of the second area.

According to some embodiments, the first ratio is substantially equal to the second ratio in the first area, the first ratio is substantially equal to the second ratio in the second area, and the first ratio is substantially equal to the second ratio in the third area.

According to some embodiments, the first heat exchanger further includes a plurality of check valves in the first pipes between the second area and the third area.

According to some embodiments, the plurality of check valves includes a first portion including a first sub-portion extending in the second direction and a second sub-portion bent from the first sub-portion and inclined at a first angle with respect to the second direction and a second portion including a third sub-portion bent from the second sub-portion and inclined at a second angle greater than the first angle with respect to the first direction and a fourth sub-portion bent from the third sub-portion and extending in the second direction.

According to some embodiments, the second portion includes at least a one flow control member spaced apart from the third sub-portion with a predetermined distance, and the flow control member overlaps the third sub-portion when viewed in the second direction.

According to some embodiments, the first angle is about 25 degrees, and the second angle is about 60 degrees.

According to some embodiments, the pulsating heat pipe is provided in plural, and the pulsating heat pipes are arranged in the first direction or the second direction.

According to some embodiments, the pulsating heat pipe is provided in plural, some pulsating heat pipes among the pulsating heat pipes are arranged in the first direction, and the other pulsating heat pipes among the pulsating heat pipes are arranged in the second direction.

According to some embodiments, the first pipe has a polygonal shape when viewed in a cross-section defined by the first direction and a third direction intersecting the second direction.

According to some embodiments, the pulsating heat pipe includes a first plate including a first surface defined by the first direction and the second direction and a second surface opposite to the first surface and a second plate on the first surface, and the first plate is recessed in a third direction intersecting the second direction and defined by a recessed portion extending in the third direction.

Aspects of some embodiments of the present disclosure include a display device including a display module including a lower surface defined by a first direction and a second direction intersecting the first direction and an upper surface opposite to the lower surface and displaying an image and a heat pipe on the lower surface of the display module. According to some embodiments, the heat pipe includes a first heat exchanger including a plurality of first pipes arranged in the first direction, a plurality of second pipes connecting the first pipes most adjacent to each other among the first pipes, and a first fluid filled in the first pipes and the second pipes and existing in a liquid state or a gaseous state, and a second heat exchanger spaced apart from the first heat exchanger in the second direction and including a plurality of third pipes arranged in the first direction, a plurality of fourth pipes connecting the third pipes most adjacent to each other among the third pipes, and a second fluid filled in the third pipes and the fourth pipes and existing in a liquid state or a gaseous state. According to some embodiments, the first heat exchanger and the second heat exchanger are symmetrical with each other.

According to some embodiments, the heat pipe is provided with a pulsating heat pipe, each of the first and second heat exchangers includes a first area, a second area adjacent to the first area, and a third area spaced apart from the first area with the second area interposed therebetween, the third area is insulated, the second area has a temperature greater than a temperature of the first area, and the third area has a temperature lower than a temperature of the second area.

According to some embodiments, the first heat exchanger further includes a plurality of check valves in the first pipes between the second area and the third area.

According to some embodiments, the plurality of check valves includes a first portion including a first sub-portion extending in the second direction and a second sub-portion bent from the first sub-portion and inclined at a first angle with respect to the second direction and a second portion including a third sub-portion bent from the second sub-portion and inclined at a second angle greater than the first angle with respect to the first direction and a fourth sub-portion bent from the third sub-portion and extending in the second direction.

According to some embodiments, the second portion further includes at least a one flow control member spaced apart from the third sub-portion with a predetermined distance, and the flow control member overlaps the third sub-portion when viewed in the second direction.

According to some embodiments, the heat pipe includes a first plate including a first surface defined by the first direction and the second direction and a second surface opposite to the first surface and a second plate on the first surface, and the first plate is recessed in a third direction intersecting the second direction and defined by a recessed portion extending in the third direction.

According to some embodiments, a display device may be capable of preventing or reducing heat-induced defects in the display panel.

According to an aspect, there is provided a display device as set out in claim 1. Additional features are set out in claims 2 to 12.

According to an aspect, there is provided a display device as set out in claim 13. Additional features are set out in claims 14 and 15.

According to some embodiments, the display device may be able to facilitate a heat transfer between the display panel and the pulsating heat pipe even when the display panel is vertically arranged with respect to a ground.

### BRIEF DESCRIPTION OF THE DRAWINGS

The patent or application file contains at least one drawing executed in color. Copies of this patent or patent application publication with color drawing(s) will be provided by the Office upon request and payment of the necessary fee.

The above and other characteristics of embodiments according to the present disclosure will become more readily apparent by reference to the following detailed description when considered in conjunction with the accompanying drawings wherein:
FIG. 1A is a perspective view of a display device according to some embodiments of the present disclosure;
FIG. 1B is an exploded perspective view of a display device according to some embodiments of the present disclosure;
FIG. 2 is a cross-sectional view of a display module according to some embodiments of the present disclosure;
FIG. 3 is a plan view of a display panel according to some embodiments of the present disclosure;
FIG. 4A is a plan view of a state in which a display module overlaps a pulsating heat pipe according to some embodiments of the present disclosure;
FIG. 4B is a cross-sectional view of a display module and a pulsating heat pipe according to some embodiments of the present disclosure;
FIGS. 5A to 5C are enlarged cross-sectional views of a portion of pulsating heat pipes according to some embodiments of the present disclosure;
FIG. 6 is a plan view of a heat exchanger of a pulsating heat pipe according to some embodiments of the present disclosure;
FIG. 7 is a plan view of a pulsating heat pipe according to some embodiments of the present disclosure;
FIGS. 8A to 8E are plan views of pulsating heat pipes according to some embodiments of the present disclosure;
FIG. 9A is an enlarged view of a portion of the pulsating heat pipe shown in FIG. 7;
FIG. 9B is an enlarged view of a check valve shown in FIG. 9A;
FIG. 10 is a graph illustrating a diodicity value of check valves according to some embodiments of the present disclosure;
FIGS. 11A to 11D are enlarged views of check valves according to some embodiments of the present disclosure;
FIG. 11E is a graph illustrating a diodicity value of check valves according to some embodiments of the present disclosure; and
FIGS. 12A to 12F are schematic views illustrating an arrangement relationship of pulsating heat pipes according to some embodiments of the present disclosure.

### DETAILED DESCRIPTION

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, aspects of some embodiments of the present disclosure will be described in more detail with reference to accompanying drawings.

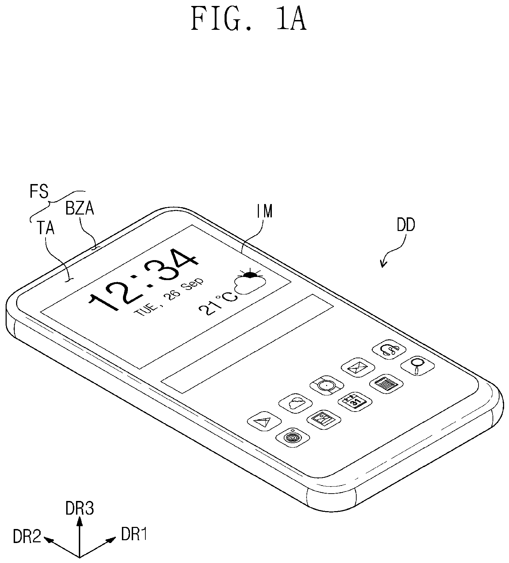

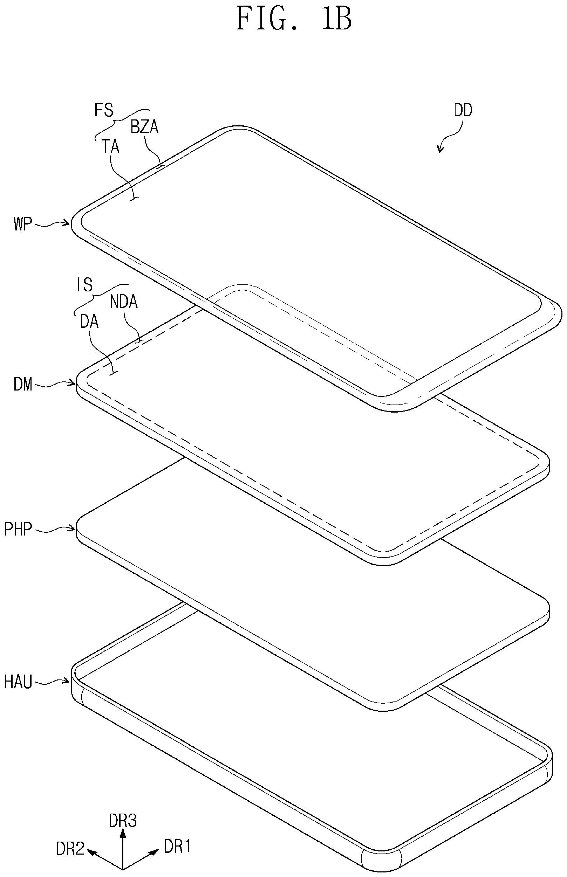

FIG. 1A is a perspective view of a display device DD according to some embodiments of the present disclosure, and FIG. 1B is an exploded perspective view of the display device DD according to some embodiments of the present disclosure.

The display device DD may be applied to a large-sized electronic item, such as a television set, a monitor, and an outdoor billboard. In addition, the display device DD may be applied to a small and medium-sized electronic item, such as a personal computer, a notebook computer, a personal digital assistant, a car navigation unit, a game unit, a smartphone, a tablet computer, and a camera. In FIGS. 1A and 1B, a smart phone, which is a small-sized electronic item, is shown as the display device DD. However, these are merely examples, and the display device DD may be employed in other electronic items as long as they do not depart from the concept of embodiments according to the present disclosure and may be a medium and large-sized electronic item.

Referring to FIGS. 1A and 1B, the display device DD may display an image IM through a display surface FS, which is parallel (or substantially parallel) to each of a first direction DR1 and a second direction DR2, toward a third direction DR3. The image IM may include a video and a still image. FIG. 1A shows a clock widget and application icons as a representative example of the image IM. The display surface FS through which the image IM is displayed may correspond to a front surface of the display device DD.

In the present embodiments, front (or upper) and rear (or lower) surfaces of each member of the display device DD may be defined with respect to a direction in which the image IM is displayed. The front and rear surfaces may be opposite to each other in the third direction DR3, and a normal line direction of each of the front and rear surfaces may be substantially parallel to the third direction DR3. Meanwhile, directions indicated by the first, second, and third directions DR1, DR2, and DR3 may be relative to each other and may be changed to other directions. In the following descriptions, the expression "when viewed in a plane" or "in a plan view" refers to a state of being viewed in the third direction DR3.

The display device DD may include a window WP, a display module DM, a pulsating heat pipe PHP, and a housing HAU. The window WP and the housing HAU may be coupled to each other to provide an exterior of the display device DD.

The window WP may include an optically transparent insulating material. For example, the window WP may include a glass or plastic material. A front surface of the window WP may define the display surface FS of the display device DD. The display surface FS may include a transmissive area TA and a bezel area BZA. The transmissive area TA may be an optically transparent area. As an example, the transmissive area TA may be an area having a visible light transmittance of 90% (or about 90%) or more.

The bezel area BZA may be an area having a relatively lower transmittance than that of the transmissive area TA. The bezel area BZA may define a shape of the transmissive area TA. The bezel area BZA may be located adjacent to the transmissive area TA and may surround the transmissive area TA. However, this is merely an example, and the bezel area BZA may be omitted from the window WP. The window WP may include at least one functional layer of an anti-fingerprint layer, a hard coating layer, and an anti-reflective layer and should not be particularly limited.

The display module DM may be located under the window WP. The display module DM may have a configuration that substantially generates the image IM. The image IM generated by the display module DM may be displayed through a display surface IS of the display module DM and may be viewed by a user through the transmissive area TA.

The display module DM may include a display area DA and a non-display area NDA. The display area DA may be activated in response to electrical signals. The non-display area NDA may be adjacent to (e.g., in a periphery or outside a footprint of) the display area DA. The non-display area NDA may surround the display area DA. The non-display area NDA may be covered by the bezel area BZA and may not be viewed from the outside.

The pulsating heat pipe PHP may be located under the display module DM. The pulsating heat pipe PHP may cool down the display module DM. For example, the pulsating heat pipe PHP may serve as a heat exchanger, and heat transfer may occur between the heat generated from the display module DM and a fluid flowing through the pulsating heat pipe PHP. The pulsating heat pipe PHP will be described in more detail later.

The housing HAU may be coupled with the window WP. The housing HAU and the window WP, which are coupled to each other, may provide an inner space (e.g., a set or predetermined inner space). The display module DM may be accommodated in the inner space.

The housing HAU may include a material with a relatively high rigidity. As an example, the housing HAU may include a plurality of frames and/or plates formed of glass, plastic, metal material, or combinations thereof. The housing HAU may stably protect the components of the display device DD accommodated in the inner space from external impacts.

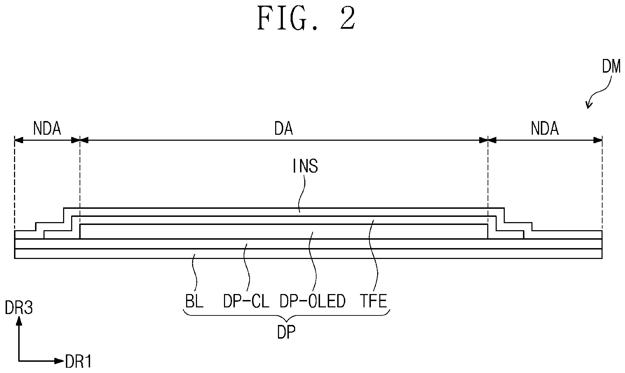

FIG. 2 is a cross-sectional view of the display module DM according to some embodiments of the present disclosure.

Referring to FIG. 2, the display module DM may include a display panel DP and an input sensor INS. According to some embodiments, the display device DD (refer to FIG. 1A) may further include a protective member located on a lower surface of the display panel DP or an anti-reflective member and/or a window member located on an upper surface of the input sensor INS.

The display panel DP may be a light emitting type display panel, however, it should not be particularly limited. For example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot, a quantum rod, or a micro-LED. Hereinafter, the organic light emitting display panel will be described as the display panel DP.

The display panel DP may include a base layer BL, a circuit element layer DP-CL, a display element layer DP-OLED, and a thin film encapsulation layer TFE. The circuit element layer DP-CL, the display element layer DP-OLED, and the thin film encapsulation layer TFE may be located on the base layer BL. The input sensor INS may be located directly on the thin film encapsulation layer TFE. In the present disclosure, the expression "A component A is located directly on a component B." means that no adhesive layers are present between the component A and the component B.

The base layer BL may include at least one plastic film. The base layer BL may be a flexible substrate and may include a plastic substrate, a glass substrate, a metal substrate, or an organic/inorganic composite material substrate. The display area DA and the non-display area NDA described with reference to FIG. 1B may be defined in the base layer BL.

The circuit element layer DP-CL may include at least one insulating layer and a circuit element. The insulating layer may include at least one inorganic layer and at least one organic layer. The circuit element may include signal lines and a pixel driving circuit.

The display element layer DP-OLED may include a barrier wall and a light emitting element. The light emitting element may include an anode, an intermediate layer, and a cathode.

The thin film encapsulation layer TFE may include a plurality of thin layers. Some thin layers may be arranged to improve an optical efficiency, and some thin layers may be arranged to protect organic light emitting diodes.

The input sensor INS may obtain coordinate information of an external input. The input sensor INS may have a multi-layer structure. The input sensor INS may include a conductive layer having a single-layer or multi-layer structure. The input sensor INS may include an insulating layer having a single-layer or multi-layer structure. The input sensor INS may sense the external input by a capacitive method, however, embodiments according to the present disclosure should not be limited thereto or thereby. As an example, the input sensor INS may sense the external input by an electromagnetic induction method or a pressure sensing method. Meanwhile, according to some embodiments, the input sensor INS may be omitted.

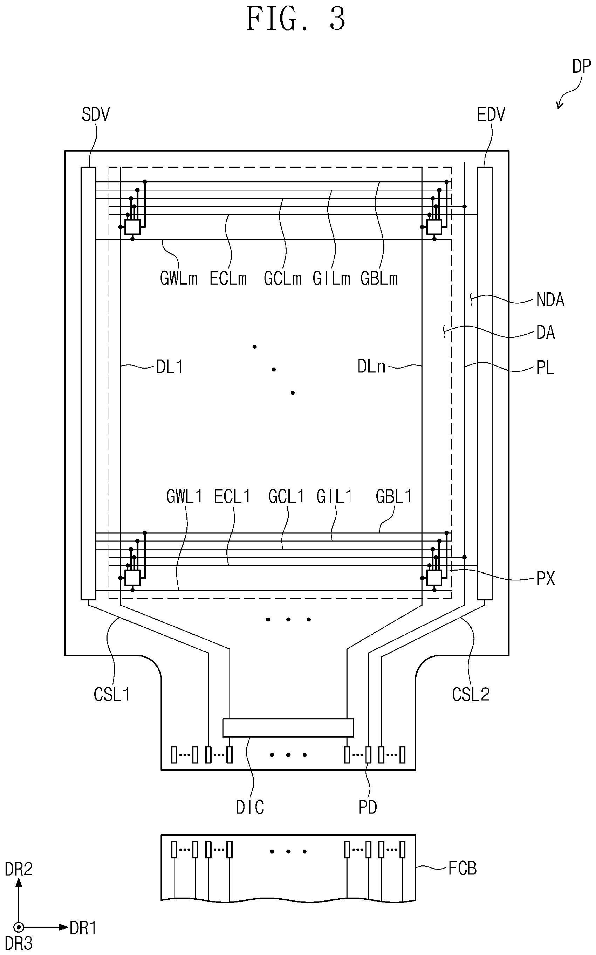

FIG. 3 is a plan view of the display panel DP according to some embodiments of the present disclosure.

Referring to FIG. 3, the display panel DP may include the display area DA and the non-display area NDA around the display area DA. The display area DA and the non-display area NDA may be distinguished from each other by a presence or absence of pixels PX. The pixels PX may be located in the display area DA. A scan driver SDV, a data driver, and an emission driver EDV may be located in the non-display area NDA. The data driver may be a circuit provided in a driving chip DIC.

The display panel DP may include the pixels PX, a plurality of initialization scan lines GIL1 to GILm, a plurality of compensation scan lines GCL1 to GCLm, a plurality of write scan lines GWL1 to GWLm, a plurality of black scan lines GBL1 to GBLm, a plurality of emission control lines ECL1 to ECLm, a plurality of data lines DL1 to DLn, first and second control lines CSL1 and CSL2, a driving voltage line PL, and a plurality of pads PD. In the present embodiments, each of the "m" and the "n" may be a natural number equal to or greater than 2.

The pixels PX may be connected to the initialization scan lines GIL1 to GILm, the compensation scan lines GCL1 to GCLm, the write scan lines GWL1 to GWLm, the black scan lines GBL1 to GBLm, the emission control lines ECL1 to ECLm, and the data lines DL1 to DLn.

The initialization scan lines GIL1 to GILm, the compensation scan lines GCL1 to GCLm, the write scan lines GWL1 to GWLm, and the black scan lines GBL1 to GBLm may extend in a direction parallel to the first direction DR1 and may be electrically connected to the scan driver SDV. The data lines DL1 to DLn may extend in a direction parallel to the second direction DR2 and may be electrically connected to the driving chip DIC. The emission control lines ECL1 to ECLm may extend in the first direction DR1 and may be electrically connected to the emission driver EDV.

The driving voltage line PL may include a portion extending in the first direction DR1 and a portion extending in the second direction DR2. The portion extending in the first direction DR1 and the portion extending in the second direction DR2 may be located on different layers from each other. The driving voltage line PL may provide a driving voltage to the pixels PX.

The first control line CSL1 may be connected to the scan driver SDV. The second control line CSL2 may be connected to the emission driver EDV.

The driving chip DIC, the driving voltage line PL, the first control line CSL1, and the second control line CSL2 may be electrically connected to the pads PD. A flexible circuit film FCB may be electrically connected to the pads PD through an anisotropic conductive adhesive layer. The pads PD may connect the flexible circuit film FCB to the display panel DP. The pads PD may be connected to corresponding pixels PX through the driving voltage line PL, the first control line CSL1, and the second control line CSL2.

In addition, the pads PD may further include input pads. The input pads may connect the flexible circuit film FCB to the input sensor INS (refer to FIG. 2), however, embodiments of the present disclosure should not be limited thereto or thereby. According to some embodiments, the input pads may be located in the input sensor INS and may be connected to a circuit board different from a circuit board to which the pads PD are connected. According to some embodiments, the input sensor INS may be omitted, and the pads PD may not further include the input pads.

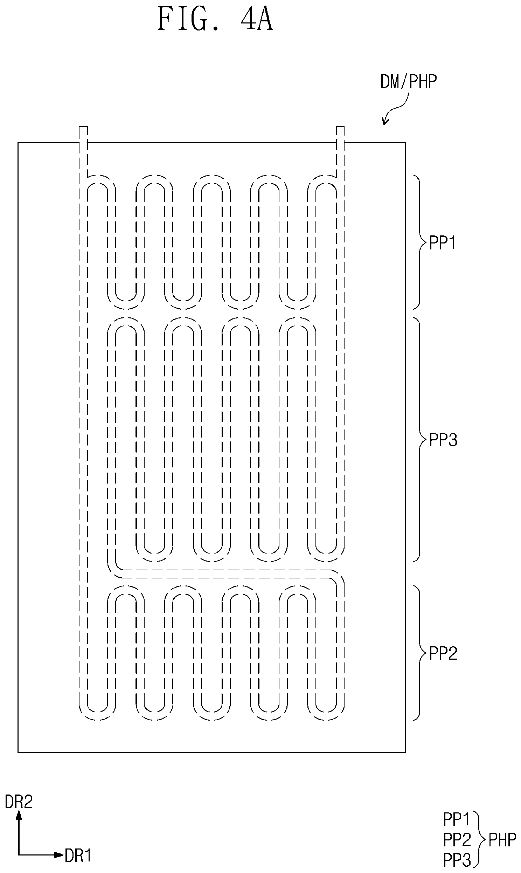

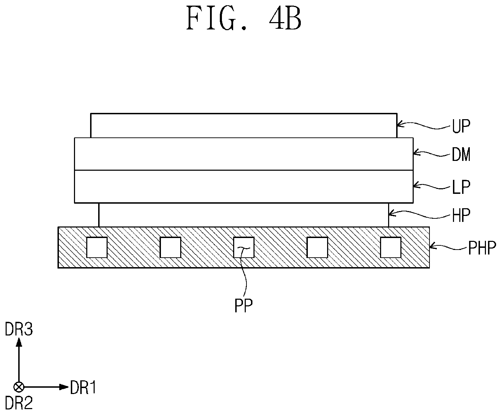

FIG. 4A is a plan view of a state in which the display module DM overlaps the pulsating heat pipe PHP according to some embodiments of the present disclosure, and FIG. 4B is a cross-sectional view of the display module DM and the pulsating heat pipe PHP according to some embodiments of the present disclosure.

Referring to FIG. 4A, the display module DM may overlap the pulsating heat pipe PHP when viewed in a plane.

The pulsating heat pipe PHP may include a first heat exchanger PP1, a second heat exchanger PP2, and a third heat exchanger PP3. The first heat exchanger PP1, the second heat exchanger PP2, and the third heat exchanger PP3 may include a plurality of pipes.

The pipes may be arranged to overlap the display module DM, and the display module DM may be cooled through heat exchange between the heat generated from the display module DM and the fluid flowing through the pipes.

The first heat exchanger PP1 may be spaced apart from the second heat exchanger PP2 in the second direction DR2. The third heat exchanger PP3 may be located between the first heat exchanger PP1 and the second heat exchanger PP2. As shown in FIG. 4A, the first heat exchanger PP1 and the second heat exchanger PP2 may be linearly symmetrical with each other based on a direction substantially parallel to the first direction DR1, however, embodiments of the present disclosure should not be limited thereto or thereby. The first heat exchanger PP1 and the second heat exchanger PP2 may be point-symmetrical with respect to a point, e.g., a center of the pulsating heat pipe PHP, between the first heat exchanger PP1 and the second heat exchanger PP2.

According to the present disclosure, a length in the second direction DR2 of the pulsating heat pipe PHP may be equal to or greater than 400 millimeters (mm) (or about 400 mm), and a length in the first direction DR1 of the pulsating heat pipe PHP may be equal to or greater than 100 mm (or about 100 mm). In addition, a length in the second direction DR2 of the first heat exchanger PP1 may be greater than 0% (or about 0%) and equal to or smaller than 20% (or about 20%) of the length in the second direction DR2 of the entire pulsating heat pipe PHP. In addition, a length in the second direction DR2 of the second heat exchanger PP2 may be greater than about 0% and equal to or smaller than 20% (or about 20%) of the length in the second direction DR2 of the entire pulsating heat pipe PHP.

Even though the length in the second direction DR2 of each of the first heat exchanger PP1 and the second heat exchanger PP2 is greater than 0% (or about 0%) and equal to or smaller than 20% (or about 20%) of the length in the second direction DR2 of the entire pulsating heat pipe PHP and the length in the second direction DR2 of the pulsating heat pipe PHP is equal to or greater than 400 millimeters (mm) (or about 400 mm), the fluid may flow smoothly through the first heat exchanger PP1 and the second heat exchanger PP2.

According to some embodiments, the length in the second direction DR2 of each of the first heat exchanger PP1 and the second heat exchanger PP2 may be greater than 0% (or about 0%) and equal to or smaller than 10% (or about 10%) of the length in the second direction DR2 of the entire pulsating heat pipe PHP, however, embodiments of the present disclosure should not be limited thereto or thereby.

Referring to FIG. 4B, the pulsating heat pipe PHP may be located under the display module DM.

An upper member UP may be located on the display module DM. The upper member UP may be the window WP described above, however, the upper member UP should not be limited thereto or thereby and may include an optical member.

A lower member LP may be located under the display module DM. The lower member LP may include a support member, however, the lower member LP should not be limited thereto or thereby and may include an electronic module.

A heat exchange member HP may be located under the lower member LP. The heat exchange member HP may facilitate the heat exchange between the pulsating heat pipe PHP and the display module DM.

FIG. 4B shows the structure in which the lower member LP and the heat exchange member HP are located between the pulsating heat pipe PHP and the display module DM, however, embodiments according to the present disclosure should not be limited thereto or thereby. According to some embodiments, the lower member LP or the heat exchange member HP may be omitted.

A pipe PP may be located in the pulsating heat pipe PHP. The pipe PP may be provided in plural. The fluid may flow through the pipes PP. The display module DM may be cooled through the heat exchange between the heat generated from the display module DM and the fluid flowing through the pipes PP.

As shown in FIG. 4B, the pipe PP may have a polygonal shape when viewed in a cross-section parallel to the third direction DR3, however, embodiments of the present disclosure should not be limited thereto or thereby. According to some embodiments, the pipe PP may have a circular shape when viewed in the cross-section.

The pipe PP may have a diameter that varies depending on the fluid applied to the pulsating heat pipe PHP.

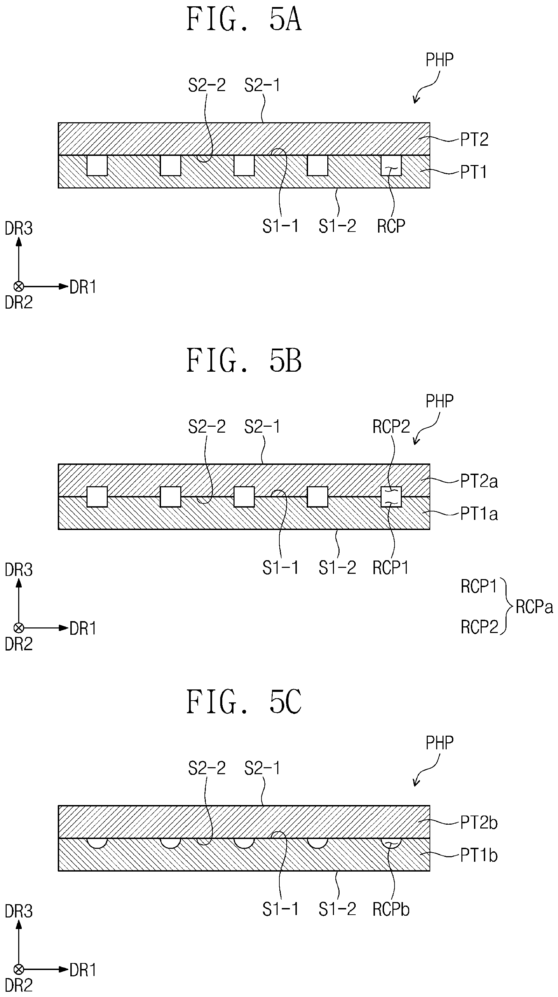

FIGS. 5A to 5C are enlarged cross-sectional views of a portion of pulsating heat pipes according to some embodiments of the present disclosure.

Referring to FIG. 5A, the pulsating heat pipe PHP may include a first plate PT1 and a second plate PT2.

The first plate PT1 may include a first-first surface S1-1 and a first-second surface S1-2 opposite to the first-first surface S1-1. The first-first surface S1-1 and the first-second surface S1-2 may extend in the first direction DR1 and the second direction DR2.

The second plate PT2 may include a second-first surface S2-1 and a second-second surface S2-2 opposite to the second-first surface S2-1. The second-first surface S2-1 and the second-second surface S2-2 may extend in the first direction DR1 and the second direction DR2. The second-second surface S2-2 may be in contact with the first-first surface S1-1.

A recessed portion RCP may be defined in the first-first surface S1-1 of the first plate PT1. The recessed portion RCP may be recessed from the first-first surface S1-1 toward the first-second surface S1-2. The recessed portion RCP may correspond to the pipe PP (refer to FIG. 4B). That is, the fluid may flow through the recessed portion RCP.

According to the present disclosure, a sum of a length of the first plate PT1 and a length of the second plate PT2 in the third direction DR3 may be equal to or smaller than 5.5 mm (or about 5.5 mm), i.e., a sum of a thickness of the first plate PT1 and a thickness of the second plate PT2 in the third direction DR3 may be equal to or smaller than 5.5 mm (or about 5.5 mm). According to some embodiments, the sum of the thickness of the first plate PT1 and the thickness of the second plate PT2 in the third direction DR3 may be equal to or smaller than 2 mm (or about 2 mm). As an example, the thickness of the first plate PT1 may be equal to or smaller than 1.5 mm (or about 1.5 mm), and the thickness of the second plate PT2 may be equal to or smaller than 0.5 mm (or about 0.5 mm).

However, the thickness of each of the first plate PT1 and the second plate PT2 should not be limited to the above-mentioned values and may be changed depending on designed product dimensions, fluids used in the pulsating heat pipe PHP, and a method of forming the recessed portion RCP.

According to the present disclosure, the recessed portion RCP may have a thickness equal to or smaller than 5 mm (or about 5 mm) and a width equal to or smaller than 5 mm (or about 5 mm). As an example, each of the thickness and width of the recessed portion RCP may be equal to or smaller than 2.5 mm (or about 2.5 mm), however, embodiments according to the present disclosure should not be limited thereto or thereby. According to some embodiments, the thickness of the recessed portion RCP may be equal to or smaller than 0.7 mm (or about 0.7 mm), and the width of the recessed portion RCP may be equal to or smaller than 4 mm (or about 4 mm).

The width and thickness of the recessed portion RCP should not be limited to the above-mentioned values, and the width and thickness of the recessed portion RCP may be changed depending on a fluid used in the pulsating heat pipe PHP.

The first plate PT1 and the second plate PT2 may include a metal. As an example, the first plate PT1 and the second plate PT2 may include aluminum (Al) or copper (Cu). However, the metal for the first plate PT1 and the second plate PT2 should not be limited thereto or thereby. According to some embodiments, the first plate PT1 and the second plate PT2 may include another metal, polymer, or both the metal and polymer.

Referring to FIG. 5B, a recessed portion RCPa may include a first recessed portion RCP1 and a second recessed portion RCP2.

The first recessed portion RCP1 may be defined in a first-first surface S1-1 of a first plate PT1a. The first recessed portion RCP1 may extend in a direction opposite to the third direction DR3. The second recessed portion RCP2 may be defined in a second-second surface S2-2 of a second plate PT2a. The second recessed portion RCP2 may extend in the third direction. The first recessed portion RCP1 and the second recessed portion RCP2 may correspond to the pipe shown in FIG. 4B.

Each of the first recessed portion RCP1 and the second recessed portion RCP2 may have a thickness equal to or smaller than 0.7 mm (or about 0.7 mm) and may have a width equal to or smaller than 4 mm (or about 4 mm). In addition, a sum of the thickness of the first recessed portion RCP1 and the thickness of the second recessed portion RCP2 may be equal to or smaller than 0.7 mm (or about 0.7 mm), however, it should not be limited thereto or thereby.

Referring to FIG. 5C, a recessed portion RCPb may have a circular shape formed by removing at least a portion of a first plate PT1b different from the recessed portion RCP shown in FIG. 5A. The recessed portion RCPb may be defined in a first-first surface S1-1 of a first plate PT1b. A second plate PT2b may be located on the first plate PT1b.

According to the method of forming the recessed portion RCP, the recessed portion RCP may have a polygonal shape as shown in FIG. 5A, however, it should not be limited thereto or thereby. The recessed portion RCP may have the circular shape.

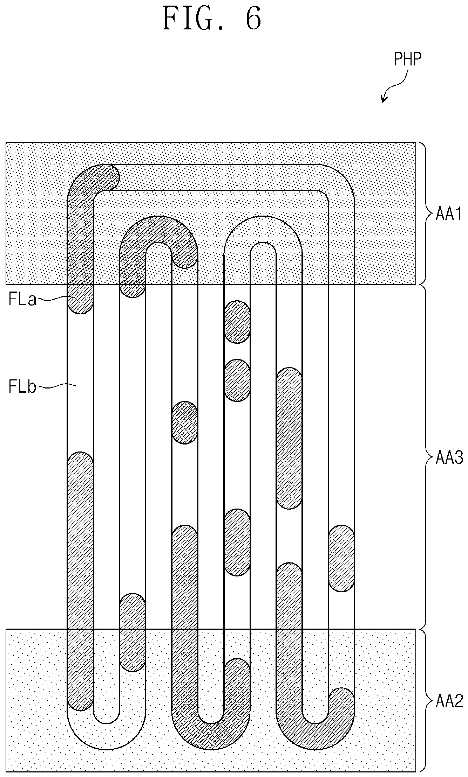

FIG. 6 is a plan view of a heat exchanger of the pulsating heat pipe according to some embodiments of the present disclosure. For example, an operation method of the pulsating heat pipe PHP according to some embodiments of the present disclosure will be described with reference to FIG. 6.

A heat pipe is a representative temperature control device that does not require an external power, and the pulsating heat pipe PHP according to the present disclosure is a heat pipe that does not have a wick structure.

In the pulsating heat pipe PHP according to some embodiments, an aligned slug-train including a liquid slug FLa and a vapor plug FLb, i.e., a fluid pool of the fluids FLa and FLb, may be formed in the pipe by evacuating an inside of the pipe to vacuum and injecting an appropriate amount of the fluids FL and FLb.

The fluids FLa and FLb may flow through a first area AA1 defined as a condenser, a second area AA2 defined as an evaporator, and a third area AA3 defined as an adiabatic portion.

When a cross-sectional diameter inside the pipe of the pulsating heat pipe PHP is equal to or smaller than a certain value, i.e., a critical diameter value, the fluids FLa and FLb filled inside the pulsating heat pipe PHP may be in the form of slug-train as described above. In this case, the critical diameter value of the pulsating heat pipe PHP may be changed depending on the type of the fluids FLa and FLb.

When heat is applied to one side of the pipe, it causes an aligned slug-train unit to vibrate at high speed, and the heat may be transferred from the evaporator to the condenser.

The flow inside the pulsating heat pipe PHP may be changed depending on the amount of heat input. When the amount of heat input is small, the fluids FLa and FLb may flow in an oscillating flow moving in both directions with small amplitude, and the amplitude of the oscillating flow may gradually increase as the amount of heat input increases. When the amount of heat input further increases, the fluids FLa and FLb may flow in a circulating flow moving in only one direction without oscillating motion. In the case of the circulating flow, the fluids FLa and FLb having a temperature sufficiently lowered while passing through the condenser may flow directly into the evaporator, and thus, a more active heat transfer effect may be expected as compared with the oscillating flow.

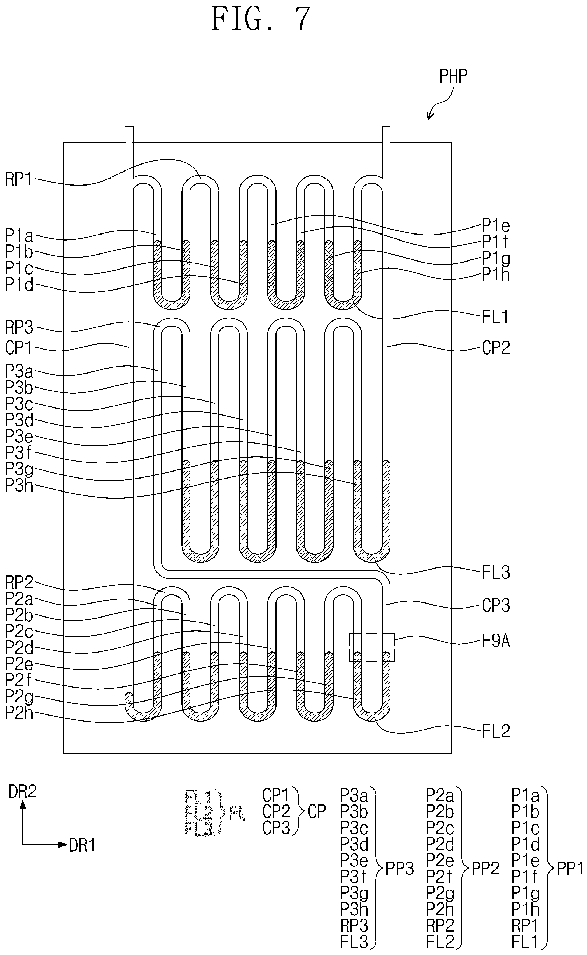

The first, second, and third areas AA1, AA2, and AA3 shown in FIG. 6 may be defined in first, second, and third heat exchangers PP1, PP2, and PP3 (refer to FIG. 7) described later, respectively.

FIG. 7 is a plan view of a pulsating heat pipe PHP according to some embodiments of the present disclosure.

For the convenience of explanation, FIG. 7 shows a structure in which fluids FL1, FL2, and FL3 are located at lower portions of a first pipes P1a to P1h, a third pipes P2a to P2h, and a fifth pipes P3a to P3h, however, the fluids FL1, FL2, and FL3 may form a fluid pool.

Referring to FIG. 7, a pulsating heat pipe PHP may include a first heat exchanger PP1, a second heat exchanger PP2, a third heat exchanger PP3, and a connection pipe CP.

The first heat exchanger PP1 may include a first pipe P1a to P1h, a second pipe RP1, and a first fluid FL1.

The first pipe P1a to P1h may be provided in plural. The first pipes P1a to P1h may be arranged in the first direction DR1.

Referring to FIG. 7, the first pipes P1a to P1h may extend in the second direction DR2. However, shapes of the first pipes P1a to P1h should not be limited to those shown in FIG. 7.

The second pipe RP1 may be provided in plural. The second pipes RP1 may connect adjacent first pipes to each other among the first pipes P1a to P1h. As an example, the second pipe RP1 may connect a first pipe P1b located second from the left and a first pipe P1c located third from the left.

Referring to FIG. 7, the second pipes RP1 may be bent. However, shapes of the second pipes RP1 should not be limited to those shown in FIG. 7.

According to some embodiments, the pulsating heat pipe PHP may include at least five first pipes P1a to P1h. As the pulsating heat pipe PHP includes at least five first pipes P1a to P1h, a heat exchange efficiency of a fluid FL1, FL2, and FL3 may increase. In addition, the pulsating heat pipe PHP may include at least five second pipes RP1.

As shown in FIG. 7, an end of one pipe of the first pipes P1a to P1h and the second pipes RP1 may not be connected to another pipe, however, embodiments of the present disclosure should not be limited thereto or thereby. According to some embodiments, ends of the first pipes P1a to P1h and ends of the second pipes RP1 may be connected to other pipes.

The first fluid FL1 may be filled in the first pipes P1a to P1h and the second pipes RP1. The first fluid FL1 may flow through the first pipes P1a to P1h and the second pipes RP1. A portion of the first fluid FL1 may exist in a gaseous state, and the other portion of the first fluid FL1 may exist in a liquid state. That is, the first fluid FL1 in the gaseous state and the first liquid FL1 in the liquid state may coexist within the first pipes P1a to P1h and the second pipes RP1.

A filling rate of the first fluid FL1 in the first heat exchanger PP1 may be equal to or greater than 35% (or about 35%) and equal to or smaller than about 80%. According to some embodiments, the filling rate of the first fluid FL1 in the first heat exchanger PP1 may be equal to or greater than 35% (or about 35%) and equal to or smaller than 50% (or about 50%). Accordingly, the first fluid FL1 may smoothly flow through the pipes P1a to P1h and RP1 of the first heat exchanger PP1.

The first heat exchanger PP1 may include a first area (refer to AA1 of FIG. 6), a second area (refer to AA2 of FIG. 6), and a third area (refer to AA3 of FIG. 6). That is, the first area AA1 (refer to FIG. 6) may correspond to the condenser described with reference to FIG. 6, the second area AA2 (refer to FIG. 6) may correspond to the evaporator, and the third area AA3 (refer to FIG. 6) may correspond to the adiabatic portion.

According to the present disclosure, the first area AA1 (refer to FIG. 6) of the first heat exchanger PP1 may have a temperature lower than a temperature of the second area AA2 (refer to FIG. 6) of the first heat exchanger PP1. In addition, the temperature of the first area AA1 (refer to FIG. 6) may be lower than a temperature of the third area AA3 (refer to FIG. 6), and the temperature of the third area AA3 (refer to FIG. 6) may be lower than the temperature of the second area AA2 (refer to FIG. 6).

A first ratio, which is defined as a ratio of the first fluid FL1 in the gaseous state to the first fluid FL1 in the liquid state, may be different in each of the first, second, and third areas AA1, AA2, and AA3 (refer to FIG. 6). As an example, the first ratio of the first area AA1 (refer to FIG. 6) may be greater than the first ratio of the second area AA2 (refer to FIG. 6).

The second heat exchanger PP2 may include a third pipe P2a to P2h, a fourth pipe RP2, and a second fluid FL2.

The third pipe P2a to P2h may be provided in plural. The third pipes P2a to P2h may be arranged in the first direction DR1.

The third pipes P2a to P2h may be symmetrical with the first pipes P1a to P1h. Referring to FIG. 7, the third pipes P2a to P2h and the first pipes P1a to P1h may be linearly symmetrical with each other based on a direction parallel to the first direction DR1.

The fourth pipe RP2 may be provided in plural. The fourth pipes RP2 may connect adjacent third pipes to each other among the third pipes P2a to P2h.

The fourth pipes RP2 may be symmetrical with the second pipes RP1. Referring to FIG. 7, the fourth pipes RP2 may be linearly symmetrical with the second pipes RP2 based on the direction parallel to the first direction DR1.

The second fluid FL2 may be filled in the third pipes P2a to P2h and the fourth pipes RP2. The second fluid FL2 may flow through the third pipes P2a to P2h and the fourth pipes RP2. A filling rate of the second fluid FL2 in the second heat exchanger PP2 may be equal to or greater than 35% (or about 35%) and equal to or smaller than 80% (or about 80%). According to some embodiments, the filling rate of the second fluid FL2 in the second heat exchanger PP2 may be equal to or greater than 35% (or about 35%) and equal to or smaller than 50% (or about 50%).

The filling rate of the second fluid FL2 in the second heat exchanger PP2 may be equal to the filling rate of the first fluid FL1 in the first heat exchanger PP1, however, embodiments according to the present disclosure should not be limited thereto or thereby. According to some embodiments, a first filling rate of the first fluid FL1 in the first heat exchanger PP1 may be different from a second filling rate of the second fluid FL2 in the second heat exchanger PP2.

The second heat exchanger PP2 may include a first area (refer to AA1 of FIG. 6), a second area (refer to AA2 of FIG. 6), and a third area (refer to AA3 of FIG. 6).

According to some embodiments, the first area AA1 (refer to FIG. 6) of the second heat exchanger PP2 may have a temperature lower than a temperature of the second area AA2 (refer to FIG. 6) of the second heat exchanger PP2. In addition, the temperature of the first area AA1 (refer to FIG. 6) may be lower than a temperature of the third area AA3 (refer to FIG. 6), and the temperature of the third area AA3 (refer to FIG. 6) may be lower than the temperature of the second area AA2 (refer to FIG. 6).

A second ratio, which is defined as a ratio of the second fluid FL2 in the gaseous state to the second fluid FL2 in the liquid state, may be different in each of the first, second, and third areas AA1, AA2, and AA3 (refer to FIG. 6). As an example, the second ratio of the first area AA1 (refer to FIG. 6) may be greater than the second ratio of the second area AA2 (refer to FIG. 6).

The second heat exchanger PP2 may be symmetrical with the first heat exchanger PP1. According to some embodiments, the first ratio in each of the first area AA1 (refer to FIG. 6), the second area AA2 (refer to FIG. 6), and the third area AA3 (refer to FIG. 6) of the first heat exchanger PP1 may correspond to the second ratio in each of the first area AA1 (refer to FIG. 6), the second area AA2 (refer to FIG. 6), and the third area AA3 (refer to FIG. 6) of the second heat exchanger PP2. As an example, the first ratio may be equal to the second ratio in each of the first, second, and third areas AA1, AA2, and AA3 of the first and second heat exchangers PP1 and PP2.

The third heat exchanger PP3 may include a fifth pipe P3a to P3h, a sixth pipe RP3, and a third fluid FL3.

The fifth pipe P3a to P3h may be provided in plural. The fifth pipes P3a to P3h may be arranged in the first direction DR1.

Portions of the fifth pipes P3a to P3h may have the same shape as portions of the first pipes P1a to P1h, and the other portions of the fifth pipes P3a to P3h may have the same shape as portions of the third pipes P2a to P2h.

The sixth pipe RP3 may be provided in plural. The sixth pipes RP3 may connect adjacent fifth pipes to each other among the fifth pipes P3a to P3h.

Portions of the sixth pipes RP3 may have the same shape as portions of the second pipes RP1, and the other portions of the sixth pipes RP3 may have the same shape as portions of the fourth pipes RP2.

The third fluid FL3 may be filled in the fifth pipes P3a to P3h and the sixth pipes RP3. The third fluid FL3 may flow through the fifth pipes P3a to P3h and the sixth pipes RP3. A filling rate of the third fluid FL3 in the third heat exchanger PP3 may be equal to or greater than 35% (or about 35%) and equal to or smaller than 80% (or about 80%). According to some embodiments, the filling rate of the third fluid FL3 in the third heat exchanger PP3 may be equal to or greater than 35% (or about 35%) and equal to or smaller than 50% (or about 50%).

A third filling rate of the third fluid FL3 in the third heat exchanger PP3 may be equal to the first filling rate of the first fluid FL1 in the first heat exchanger PP1.

The third heat exchanger PP3 may include a first area (refer to AA1 of FIG. 6), a second area (refer to AA2 of FIG. 6), and a third area (refer to AA3 of FIG. 6).

According to some embodiments, the first area AA1 (refer to FIG. 6) of the third heat exchanger PP3 may have a temperature lower than a temperature of the second area AA2 (refer to FIG. 6). In addition, the temperature of the first area AA1 (refer to FIG. 6) may be lower than a temperature of the third area AA3 (refer to FIG. 6), and the temperature of the third area AA3 (refer to FIG. 6) may be lower than the temperature of the second area AA2 (refer to FIG. 6).

A third ratio, which is defined as a ratio of the third fluid FL3 in the gaseous state to the third fluid FL3 in the liquid state, may be different in each of the first, second, and third areas AA1, AA2, and AA3 (refer to FIG. 6). As an example, the third ratio of the first area AA1 (refer to FIG. 6) may be greater than the third ratio of the second area AA2 (refer to FIG. 6).

According to the present disclosure, the third ratio of each of the first area AA1 (refer to FIG. 6), the second area AA2 (refer to FIG. 6), and the third area AA3 (refer to FIG. 6) of the third heat exchanger PP3 may correspond to the second ratio of each of the first area AA1 (refer to FIG. 6), the second area AA2 (refer to FIG. 6), and the third area AA3 (refer to FIG. 6) of the second heat exchanger PP2 or the first ratio of each of the first area AA1 (refer to FIG. 6), the second area AA2 (refer to FIG. 6), and the third area AA3 (refer to FIG. 6) of the first heat exchanger PP1. As an example, the first ratio, the second ratio, and the third ratio may be equal to each other in each of the first, second, and third areas AA1, AA2, and AA3 of the first, second, and third heat exchangers PP1, PP2, and PP3.

The connection pipe CP may connect pipes of two heat exchangers among the first, second, and third heat exchangers PP1, PP2, and PP3. At least one fluid of the first fluid FL1 to the third fluid FL3 may be filled in the connection pipe CP.

Referring to FIG. 7, the connection pipe CP may be located at both sides of the pulsating heat pipe PHP, however, embodiments of the present disclosure should not be limited thereto or thereby. According to some embodiments, the connection pipe CP may be located between the first pipes P1a to P1h and third pipes P2a to P2h.

The connection pipe CP may be provided in plural. The connection pipes CP may include a first connection pipe CP1, a second connection pipe CP2, and a third connection pipe CP3. The first connection pipe CP1 may connect the pipes of the first and second heat exchangers PP1 and PP2. The second connection pipe CP2 may connect the pipes of the first and third heat exchangers PP1 and PP3. The third connection pipe CP3 may connect the pipes of the second and third heat exchangers PP2 and PP3. Referring to FIG. 7, the pipes of the heat exchangers PP1, PP2, and PP3 may be connected to each other by one connection pipe CP.

The first, second, and third fluids FL1, FL2, and FL3 may include water, ammonia, methanol, and ethanol, however, embodiments of the present disclosure should not be limited thereto or thereby. According to some embodiments, the first, second, and third fluids FL1, FL2, and FL3 may include R134a, HFE7000, FC72, and R290, which are types of refrigerants.

The first, second, and third fluids FL1, FL2, and FL3 may include the same material as each other, however, embodiments of the present disclosure should not be limited thereto or thereby. According to some embodiments, only two fluids among the first, second, and third fluids FL1, FL2, and FL3 may include the same material as each other.

According to some embodiments of the present disclosure, each of the heat exchangers PP1, PP2, and PP3 may be provided in plural, the fluid pool may be individually formed in each of the heat exchangers PP1, PP2, and PP3, and the heat exchangers PP1, PP2, and PP3 may be entirely located under the display module DM. As a result, the heat exchange efficiency may be improved.

In addition, because the pulsating heat pipe PHP includes plural heat exchangers PP1, PP2, and PP3 each having a size smaller than 20% (or about 20%) (or smaller than 10% (or about 10%)) with respect to a total size of the pulsating heat pipe PHP, which are provided instead of one heat exchanger with a large size, the fluid FL may smoothly flow in each of the heat exchangers PP1, PP2, and PP3.

Accordingly, as in the case where the pulsating heat pipe PHP is arranged in a horizontal direction with respect to the ground, the oscillating flow or circulating flow of the fluid FL may be easily generated even when the pulsating heat pipe PHP is arranged at an angle to the ground. In addition, in the case where the pulsating heat pipe PHP is arranged in a vertical direction with respect to the ground, the oscillating flow or the circulating flow of the fluid FL within the pipe may easily occur even with the limit of capillary pressure in the vertical direction.

In addition, when the plural heat exchangers PP1, PP2, and PP3 are arranged to be uniformly distributed to correspond to the display module DM, the heat generated from the display module DM may be uniformly transferred to the plural heat exchangers PP1, PP2, and PP3, and thus, the heat exchange efficiency may be improved.

In addition, when the heat is uniformly transferred to the plural heat exchangers PP1, PP2, and PP3, the oscillation of the fluid FL may be further generated inside the pipes of the heat exchangers PP1, PP2, and PP3. Further, active heat transfer effect may be expected by enabling the circulating flow of the fluid FL.

Further, the heat exchange efficiency may be improved by arranging the first heat exchanger PP1 and the second heat exchanger PP2 in a symmetrical structure or the first heat exchanger PP1, the second heat exchanger PP2, and portions of the third heat exchanger PP3 in a symmetrical structure.

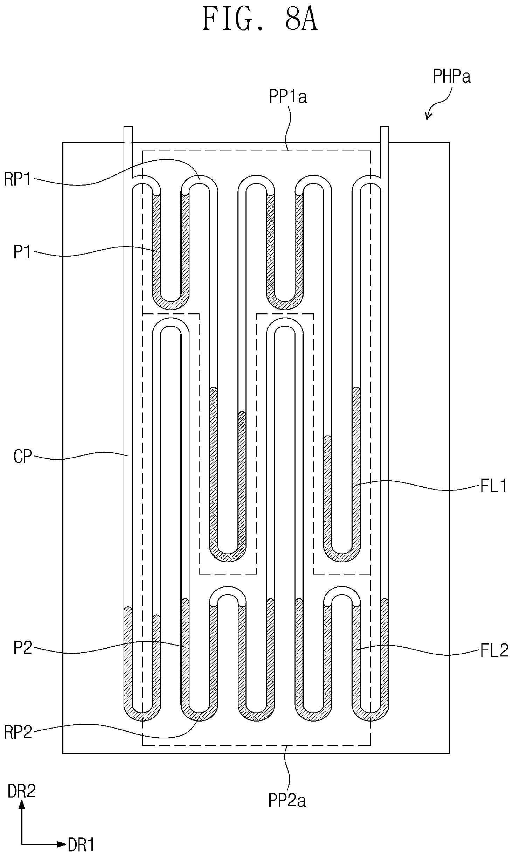

FIGS. 8A to 8E are plan views of pulsating heat pipes according to some embodiments of the present disclosure. For example, FIGS. 8A to 8E show pulsating heat pipes PHPa, PHPb, PHPc, PHPd, and PHPe different from the pulsating heat pipe PHP shown in FIG. 7.

Referring to FIG. 8A, the pulsating heat pipe PHPa may include a first heat exchanger PP1a and a second heat exchanger PP2a.

A minimum value of a length in the second direction DR2 of the first heat exchanger PP1a may be greater than 0% (or about 0%) and equal to or smaller than 20% (or about 20%) or may be greater than 0% (or about 0%) and equal to or smaller than 10% (or about 10%) of a total length in the second direction DR2 of the pulsating heat pipe PHPa. A minimum value of a length in the second direction DR2 of the second heat exchanger PP2a may be greater than 0% (or about 0%) and equal to or smaller than 20% (or about 20%) or may be greater than 0% (or about 0%) and equal to or smaller than 10% (or about 10%) of the total length in the second direction DR2 of the pulsating heat pipe PHPa.

Pipes P1 and RP1 of the first heat exchanger PP1a may overlap pipes P2 and RP2 of the second heat exchanger PP2 when viewed in the second direction DR2. In addition, the first heat exchanger PP1a and the second heat exchanger PP2a may be point-symmetrical with respect to a center of the pulsating heat pipe PHPa.

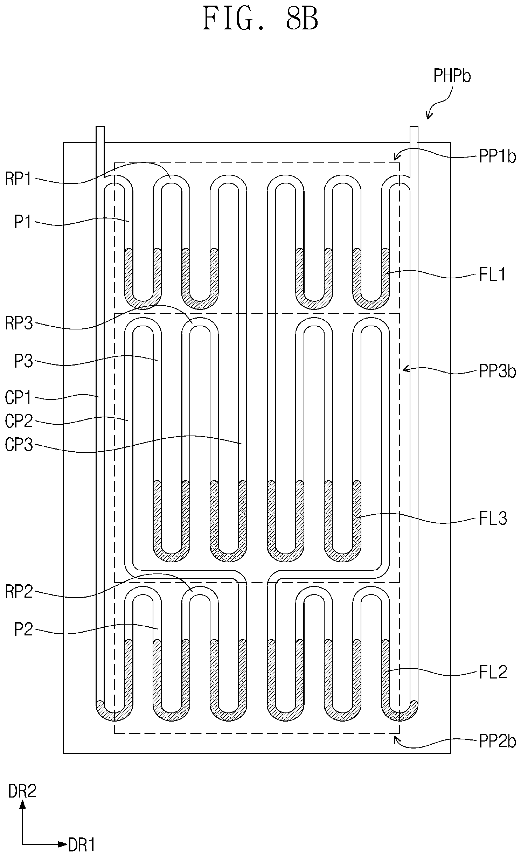

Referring to FIG. 8B, each of connection pipes CP1, CP2, and CP3 that connects pipes of two heat exchangers among a first heat exchanger PP1b, a second heat exchanger PP2b, and a third heat exchanger PP3b may be provided in plural. In addition, some connection pipes CP3 of the connection pipes CP1, CP2, and CP3 may be located at both sides and a center of the pulsating heat pipe PHPb.

Accordingly, fluids FL1, FL2, and FL3 may smoothly flow through pipes of the first, second, and third heat exchangers PP1b, PP2b, and PP3b.

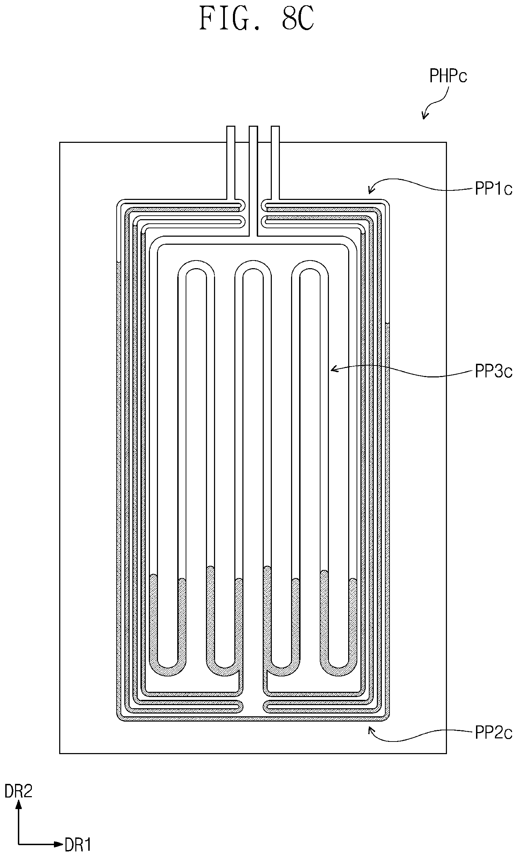

Referring to FIG. 8C, pipes of a first heat exchanger PP1c and pipes of a second heat exchanger PP2c of the pulsating heat pipe PHPc may have different cross-sectional diameters from pipes of a third heat exchanger PP3c of the pulsating heat pipe PHPc.

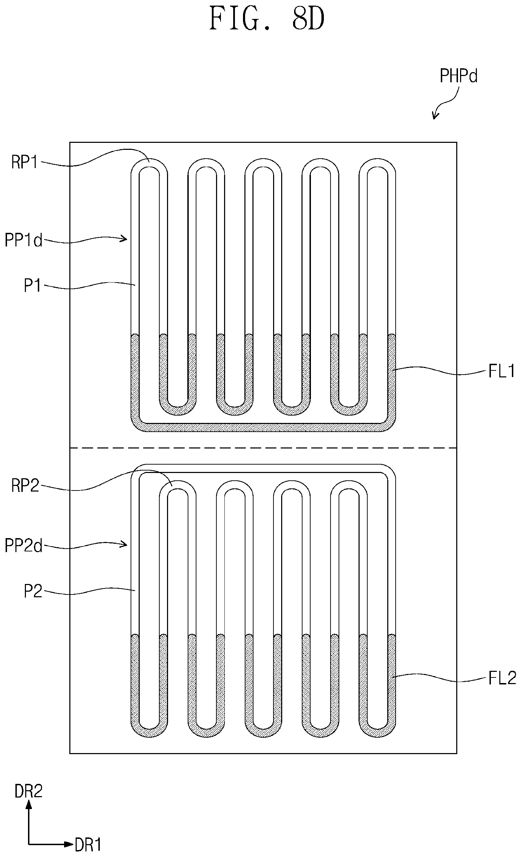

Referring to FIG. 8D, a first heat exchanger PP1d and a second heat exchanger PP2d may be linearly symmetrical with each other based on the direction parallel to the first direction DR1. First pipes P1 of the first heat exchanger PP1d and third pipes P2 of the second heat exchanger PP2 may be linearly symmetrical with each other based on the direction parallel to the first direction DR1, and second pipes RP1 of the first heat exchanger PP1d and fourth pipes RP2 of the second heat exchanger PP2 may be linearly symmetrical with each other based on the direction parallel to the first direction DR1.

In addition, the first heat exchanger PP1d and the second heat exchanger PP2d may be separated from each other. A first fluid FL1 of the first heat exchanger PP1d and a second fluid FL2 of the second heat exchanger PP2d may be different from each other.

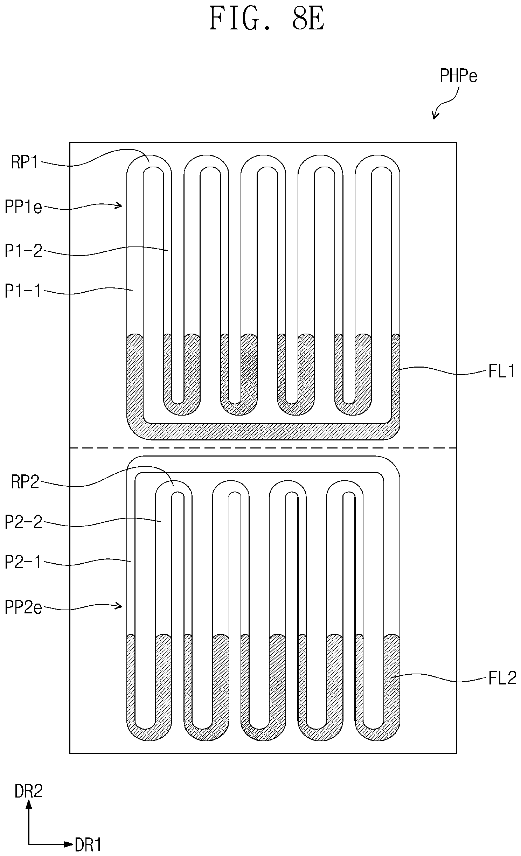

Referring to FIG. 8E, first pipes P1-1 and P1-2 of a first heat exchanger PP1e may include first-first pipes P1-1 and first-second pipes P1-2. The first-first pipes P1-1 may have a cross-sectional diameter different from that of the first-second pipes P1-2. Second pipes RP1 may connect the first-first pipes P1-1 and the first-second pipes P1-2.

Third pipes P2-1 and P2-2 of a second heat exchanger PP2e may include third-first pipes P2-1 and third-second pipes P2-2. The third-first pipes P2-1 may have a cross-sectional diameter different from that of the third-second pipes P2-2. Fourth pipes RP2 may connect the third-first pipes P2-1 and the third-second pipes P2-2.

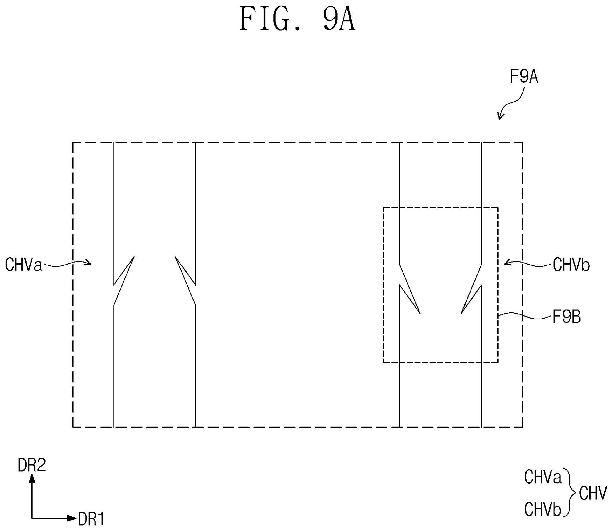

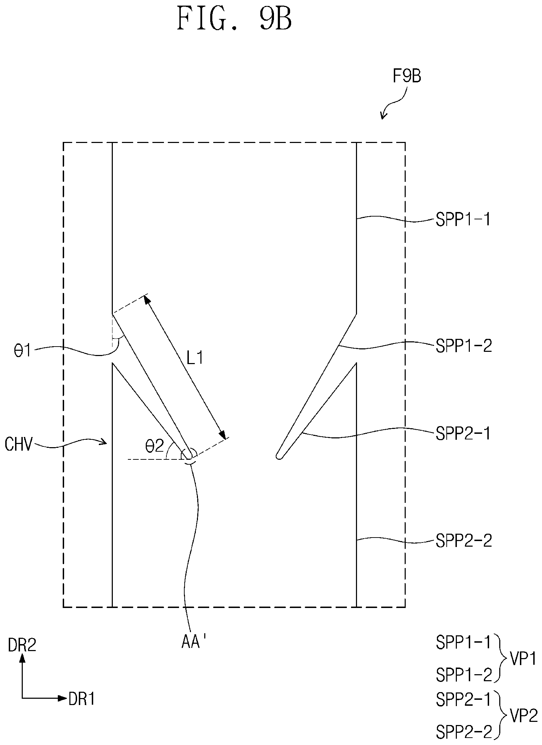

FIG. 9A is an enlarged view of a portion of the pulsating heat pipe shown in FIG. 7, and FIG. 9B is an enlarged view of a check valve shown in FIG. 9A. For example, FIG. 9A is an enlarged view of a portion F9A of FIG. 7, and FIG. 9B is an enlarged view of a portion F9B of FIG. 9A.

Referring to FIGS. 9A and 9B, the pulsating heat pipe PHP (refer to FIG. 7) may include a plurality of check valves CHV. The check valves CHV may be provided in at least one of the first, second, or third heat exchangers PP1, PP2, or PP3 (refer to FIG. 7). A check valve CHVb of the check valves CHV may facilitate the fluid to flow easily and smoothly in a direction opposite to the second direction DR2, and the other check valve CHVa of the check valves CHV may facilitate the fluid to flow easily and smoothly in the second direction DR2.

In the drawings, the check valves CHV are shown as being provided in the second heat exchanger PP2, however, embodiments according to the present disclosure should not be limited thereto or thereby. According to some embodiments, the check valves CHV may be provided in the first heat exchanger PP1, but they should not be limited thereto or thereby.

When the check valves CHV are provided to the pipes of the heat exchanger, the fluid FL may flow smoothly along one direction. Therefore, the flow of the fluid FL through the pipes may be facilitated, and thus, the heat exchange efficiency may be improved.

According to the present disclosure, the check valves CHV may be located between the second area AA2 (refer to FIG. 6) and the third area AA3 (refer to FIG. 6). That is, the check valves CHV may be located between the second area AA2 (refer to FIG. 6) where the gas is condensed and the third area AA3 (refer to FIG. 6) where the heat is insulated, however, embodiments of the present disclosure should not be limited thereto or thereby. According to some embodiments, the check valves CHV may also be located between the first area AA1 (refer to FIG. 6) and the third area AA3 (refer to FIG. 6).

Each check valve CHV may include a first portion VP1 and a second portion VP2. The first portion VP1 may include a first sub-portion SPP1-1 and a second sub-portion SPP1-2. The second portion VP2 may include a third sub-portion SPP2-1 and a fourth sub-portion SPP2-2.

The first sub-portion SPP1-1 may extend in the second direction DR2. The second sub-portion SPP1-2 may be connected to the first sub-portion SPP1-1. The second sub-portion SPP1-2 may be bent from the first sub-portion SPP1-1 and may be inclined at a first angle θ1 with respect to the second direction DR2.

The third sub-portion SPP2-1 may be connected to the second sub-portion SPP1-2. The third sub-portion SPP2-1 may be bent from the second sub-portion SPP1-2 and may be inclined at a second angle θ2 with respect to the first direction DR1. In this case, the second angle θ2 may be greater than the first angle θ1, however, embodiments of the present disclosure should not be limited thereto or thereby. According to some embodiments, the second angle θ2 may be equal to the first angle θ1.

Referring to FIG. 9B, according to some embodiments, a length in the first direction DR1 of the contact area AA' where the second sub-portion SPP1-2 is in contact with the third sub-portion SPP2-1 may be equal to or greater than 0.1 mm (or about 0.1 mm). Embodiments of the present disclosure should not be limited thereto or thereby.

The fourth sub-portion SPP2-2 may be connected to the third sub-portion SPP2-1. The fourth sub-portion SPP2-2 may be bent from the third sub-portion SPP2-1 and may extend in the direction opposite to the second direction DR2.

That is, as described with reference to FIG. 6, the circulating flow may be easily generated in the heat exchangers by the check valves. The fluid FL may flow directly into the evaporator after its temperature is sufficiently lowered while passing through the condenser by the circulating flow, and thus, the heat exchange efficiency may be improved.

For the convenience of explanation, the check valve CHV provided in the pulsating heat pipe PHP shown in FIG. 7 is shown, however, embodiments of the present disclosure should not be limited thereto or thereby. The check valve CHV may be provided in the pulsating heat pipes PHPa, PHPb, PHPc, PHPd, and PHPe shown in FIGS. 8A to 8E.

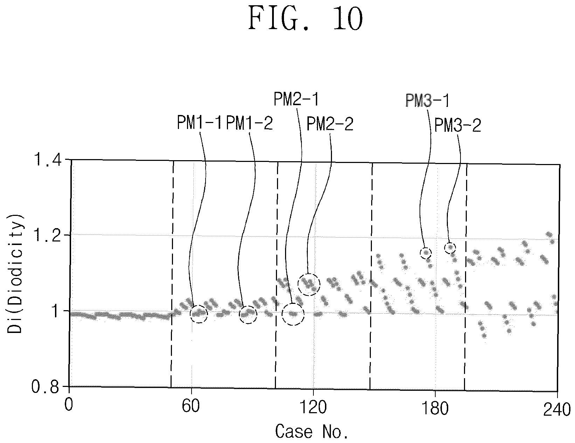

FIG. 10 is a graph illustrating a diodicity value of check valves according to some embodiments of the present disclosure.

Referring to FIGS. 9B and 10, the diodicity may vary depending on a length L1 of an inclined surface of the second sub-portion SPP1-2, the length in the second direction DR2 of the contact area AA' of the second sub-portion SPP1-2 and the third sub-portion SPP2-1, the first angle θ1, and the second angle θ2.

The diodicity is a characteristic that facilitates the flow of the fluid in one direction (e.g., a forward direction) and blocks the flow of the fluid in a direction (e.g., a reverse direction) opposite to the one direction. As the diodicity value increases, the fluid may flow more smoothly in the forward direction than in the reverse direction. The diodicity value may be expressed as a relationship between an amount of change of a fluid pressure drop value in the forward direction and an amount of change of a fluid pressure drop value in the reverse direction under the same flow conditions.

Each case described with reference to FIG. 10 corresponds to embodiments in which any one of the length L1 of the inclined surface of the second sub-portion SPP1-2, the length of the contact area AA' of the second sub-portion SPP1-2 and the third sub-portion SPP2-1, the first angle θ1, and the second angle θ2 is fixed.

The cases are grouped into five groups from a left side to a right side. The cases may be defined as first to fifth case groups from leftmost to right.

The first angle θ1 of the cases of the first case group is 5 degrees (or about 5 degrees), the first angle θ1 of the cases of the second case group is 10 degrees (or about 10 degrees), the first angle θ1 of the cases of the third case group is 15 degrees (or about 15 degrees), the first angle θ1 of the cases of the fourth case group is 20 degrees (or about 20 degrees), and the first angle θ1 of the cases of the fifth case group is 25 degrees (or about 25 degrees).

The lengths L1 of the inclined surface of the second sub-portion SPP1-2 of the cases of each of the case groups may be 0.5 mm (or about 0.5 mm), 1.0 mm (or about 1.0mm), 1.5 mm (or about 1.5 mm), and 2 mm (or about 2.0 mm), respectively. The lengths of the contact area AA' of the second sub-portion SPP1-2 and the third sub-portion SPP2-1 of the cases of each of the case groups may be 0.1 mm (or about 0.1 mm), 0.2 mm (or about 0.2 mm), and 0.3 mm (or about 0.3 mm), respectively. The second angles θ2 of the cases of each of the case groups may be 15 degrees (or about 15 degrees), 30 degrees (or about 30 degrees), 45 degrees (or about 45 degrees), and 60 degrees (or about 60 degrees), respectively.

The lengths L1 of the inclined surface of the second sub-portion SPP1-2, the lengths of the contact area AA' of the second sub-portion SPP1-2 and the third sub-portion SPP2-1, and the second angles θ2 may be different from each other in the cases of each of the case groups. However, the trend of change in diodicity value according to changes in value of the length L1 of the inclined surface of the second sub-portion SPP1-2, the length of the contact area AA' of the second sub-portion SPP1-2 and the third sub-portion SPP2-1, and the second angle θ2 may be substantially similar between the cases of the case groups.

Referring to the second case group, a first-first diodicity value PM1-1 may be substantially the same as a first-second diodicity value PM1-2.

The first-first diodicity value PM1-1 is the diodicity value when the length in the second direction DR2 of the contact area AA' is 0.1 mm (or about 0.1 mm), and the first-second diodicity value PM1-2 is the diodicity value when the length in the second direction DR2 of the contact area AA' is 0.3 mm (or about 0.3 mm). That is, as described later, even though a difference between the lengths in the second direction DR2 of contact area AA' is large, a difference in diodicity value may not be large.

Referring to the third case group, a second-second diodicity value PM2-2 is greater than a second-first diodicity value PM2-1.

The second-first diodicity value PM2-1 is the diodicity value when the lengths L1 of the inclined surface of the second sub-portion SPP1-2 is 0.5 mm (or about 0.5 mm), and the second-second diodicity value PM2-2 is the diodicity value when the lengths L1 of the inclined surface of the second sub-portion SPP1-2 is 2.0 mm (or about 2.0 mm). That is, as the first length increases, the diodicity value may increase.

Referring to the fourth case group, the third-second diodicity value PM3-2 may be greater than the third-first diodicity value PM3-1.

A third-first diodicity value PM3-1 is the diodicity value when the second angle θ2 is 45 degrees (or about 45 degrees), and a third-second diodicity value PM3-2 is the diodicity value when the second angle θ2 is 60 degrees (or about 60 degrees). That is, as the second angle θ2 increases, the diodicity value may increase.

In addition, referring to the diodicity values of each of the first to fifth case groups, as the first angle θ1 increases, the diodicity value may increase, and the difference in the first angle θ1 between the case groups may exert significant influence on the difference in the diodicity value between the case groups.

Referring to FIG. 10, the order of influences on the diodicity values from factors with a significant impact to those with a less impact is as follows, the first angle θ1, the length L1 of the inclined surface, the second angle θ2, and the length of the contact area AA'.

As an example, when the first angle θ1 is 25 degrees (or about 25 degrees), the length L1 of the inclined surface is 1.5 mm (or about 1.5 mm), the second angle θ2 is 60 degrees (or about 60 degrees), and the length of the contact area AA' is 0.1 mm (or about 0.1 mm), the diodicity value is 1.21 (or about 1.21). The check valve CHV may have excellent diodicity at the above-mentioned values. However, the values of the factors of the check valve CHV should not be particularly limited. As an example, the length of the contact area AA' may be 0.3 mm (or about 0.3 mm), and the values of some factors of the check valve CHV may be changed.

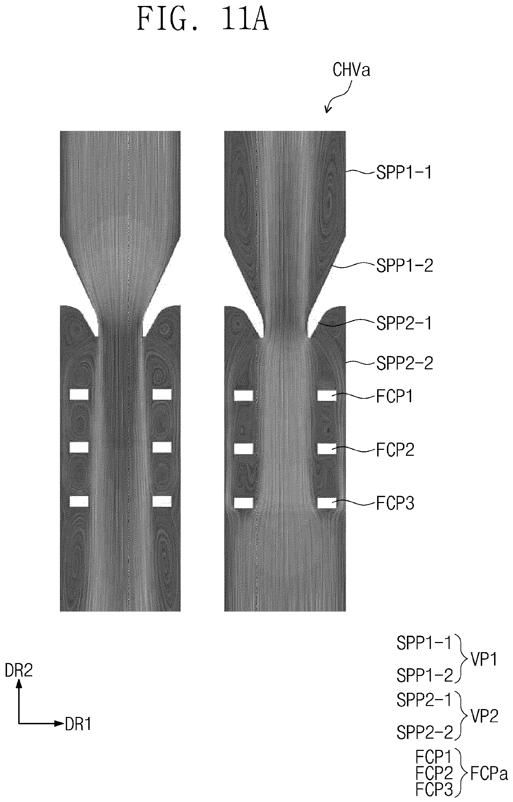

FIGS. 11A to 11D are enlarged views of check valves according to some embodiments of the present disclosure. FIGS. 11A to 11D show a flow of a fluid in check valves CHVa, CHVb, CHVc, and CHVd along a forward direction and a reverse direction. In FIGS. 11A to 11D, left portions show the flow of the fluid along the forward direction in the check valves CHVa, CHVb, CHVc, and CHVd, and right portions show the flow of the fluid along the reverse direction in the check valves CHVa, CHVb, CHVc, and CHVd.

Referring to FIG. 11A, the check valve CHVa may include a flow control member FCPa. The flow control member FCPa may be provided in plural. The flow control member FCPa may restrict a fluid path within the check valve CHVa. Accordingly, the flow control member FCPa may control the flow of the fluid in the check valve CHVa.

The flow control members FCPa may be located in a second portion VP2. Referring to FIG. 9B, when viewed in the second direction DR2, the flow control member FCPa may overlap a third sub-portion SPP2-1. In addition, when viewed in the first direction DR1, the flow control member FCPa may overlap a fourth sub-portion SPP2-2.

The flow control members FCPa may be arranged along the second direction DR2. As shown in FIG. 11A, the flow control members FCPa may include a first flow control member FCP1, a second flow control member FCP2, and a third flow control member FCP3, which are sequentially arranged along a direction away from the third sub-portion SPP2-1. In addition, three flow control members FCPa may be provided on each side of the fourth sub-portion SPP2-2. The first, second, and third flow control members FCP1, FCP2, and FCP3 may be arranged at regular intervals.

Referring to FIGS. 9B and 11A, a separation distance in the second direction DR2 between the first flow control member FCP1 and the third sub-portion SPP2-1 may be equal to or smaller than the lengths L1 of the inclined surface. A separation distance in the second direction DR2 between the first flow control member FCP1 and the second flow control member FCP2 may be smaller than the the lengths L1 of the inclined surface. However, the separation distance in the second direction DR2 between the first flow control member FCP1 and the third sub-portion SPP2-1 and the separation distance in the second direction DR2 between the first flow control member FCP1 and the second flow control member FCP2 should not be limited thereto or thereby.

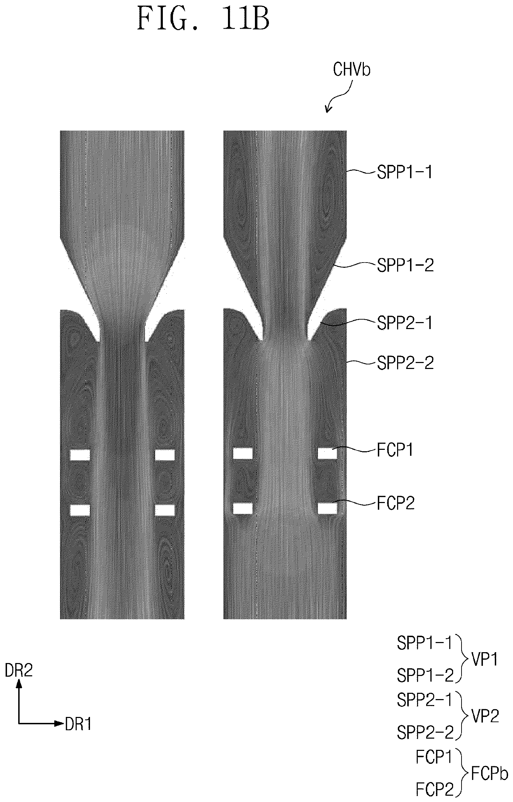

Referring to FIG. 11B, a separation distance in the second direction DR2 between a first flow control member FCP1 and a third sub-portion SPP2-1 may be greater than the lengths L1 of the inclined surface. In addition, two flow control members FCPb may be provided on each side of a fourth sub-portion SPP2-2.

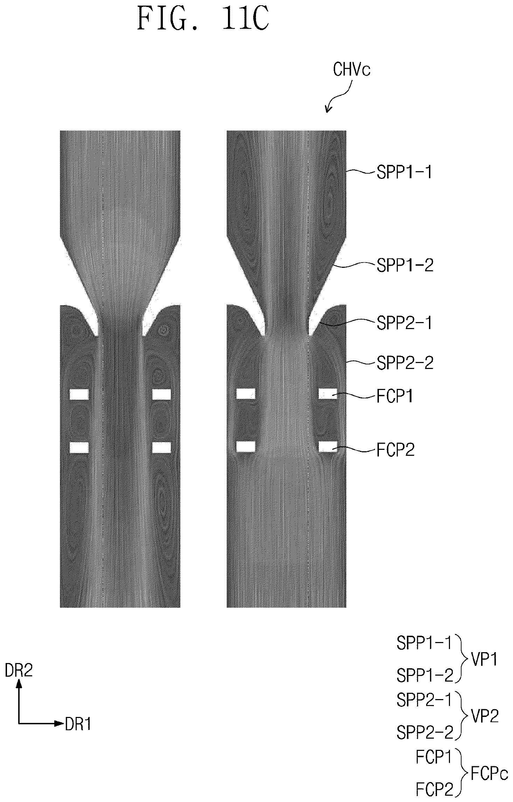

Referring to FIG. 11C, a separation distance in the second direction DR2 between a first flow control member FCP1 and a third sub-portion SPP2-1 may be equal to or smaller than the lengths L1 of the inclined surface. In addition, two flow control members FCPc may be provided on each side of a fourth sub-portion SPP2-2.

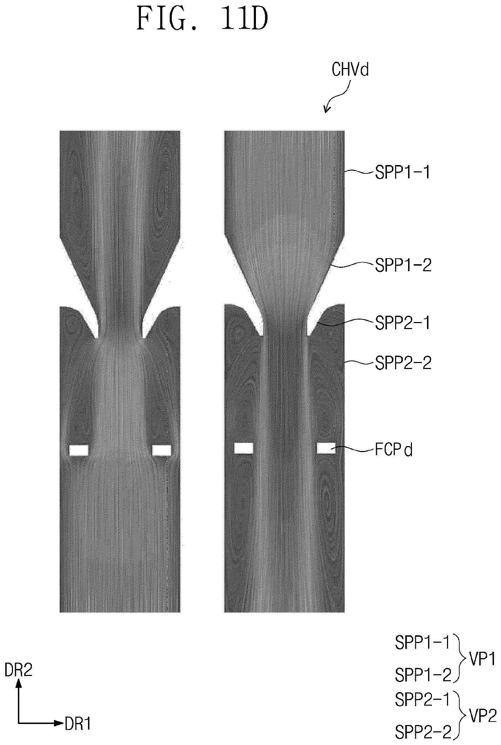

Referring to FIG. 11D, a separation distance in the second direction DR2 between a first flow control member FCP1 and a third sub-portion SPP2-1 may be greater than the lengths L1 of the inclined surface. In addition, one flow control member FCPd may be provided on each side of a fourth sub-portion SPP2-2.

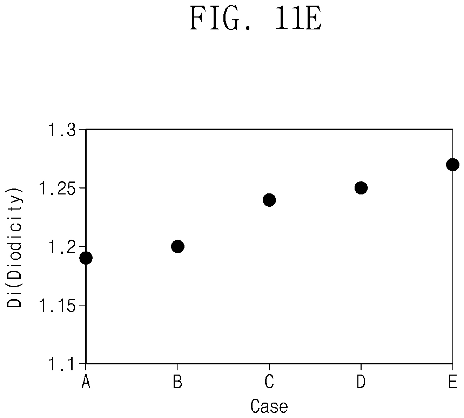

FIG. 11E is a graph illustrating a diodicity value of check valves according to some embodiments of the present disclosure.

Referring to FIG. 11E, a case A, a case B, a case C, a case D, and a case E may have different diodicity values.

The case A shows the diodicity value of the check valve CHVa shown in FIG. 11A, the case B shows the diodicity value of the check valve CHVb shown in FIG. 11B, the case C shows the diodicity value of the check valve CHVc shown in FIG. 11C, the case D shows the diodicity value of the check valve CHVd shown in FIG. 11D, and the case E shows the diodicity value of the check valve CHV (refer to FIG. 9B) excluding the flow control member FCPa (refer to FIG. 11A) according to the present disclosure.

The diodicity value of the case A is 1.19 (or about 1.19), the diodicity value of the case B is 1.20 (or about 1.20), the diodicity value of the case C is 1.24 (or about 1.24), and the diodicity value of the case D is 1.25 (or about 1.25).

That is, the case A to the case D show excellent diodicity. The diodicity values of the cases D, C, B, and A, in descending order of superiority, exhibit superior characteristics similar to case E excluded the flow control member FCPa (refer to FIG. 11A) according to the present disclosure.

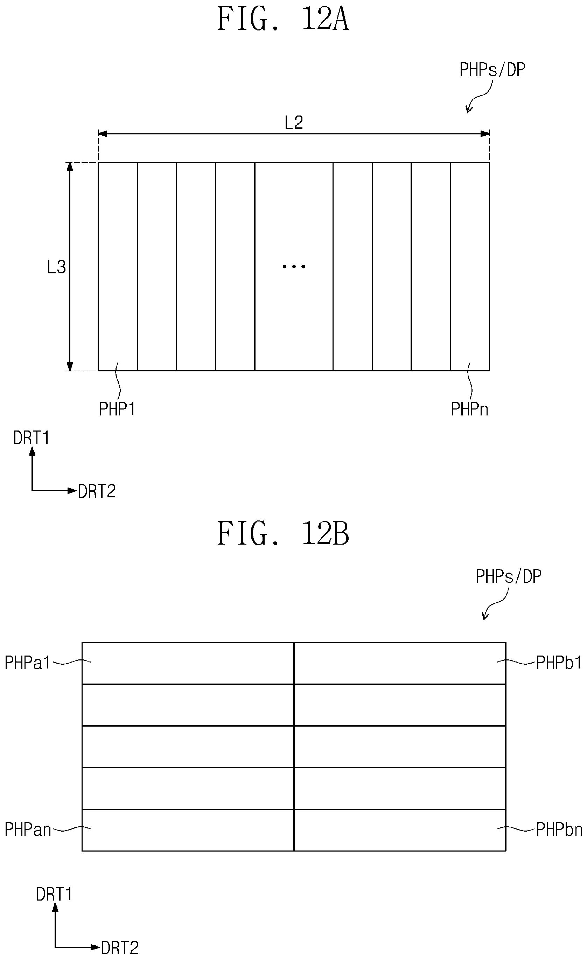

FIGS. 12A to 12F are schematic views illustrating an arrangement relationship of pulsating heat pipes PHPs according to some embodiments of the present disclosure.

A first direction DRT1 and a second direction DRT2, which are defined in FIGS. 12A to 12F, may be the same as or different from the first direction DR1 (refer to FIG. 7) and the second direction DR2 (refer to FIG. 7).

Referring to FIG. 12A, the number of pulsating heat pipes PHPs may be determined by taking into account a size of the display module DM (refer to FIG. 4A). A length in the first direction DR1 of the display module DM (refer to FIG. 4A) and a length in the second direction DR2 of the display module DM (refer to FIG. 4A) may be determined by a length in the first direction DRT1 of the display panel DP and a length in the second direction DRT2 of the display panel DP.

The pulsating heat pipes PHPs may be arranged in the second direction DRT2. For example, a first pulsating heat pipe PHP1 to an n-th pulsating heat pipe PHPn may be arranged in the second direction DRT2. In the present embodiments, n is a natural number equal to or greater than 2. Among the pulsating heat pipes PHPs, a length in the first direction DRT1 of one pulsating heat pipe PHPs may be equal to or greater than 150 mm (or about 150 mm), and a length in the second direction DRT2 of the one pulsating heat pipe PHPs may be 800 mm (or about 800 mm), however, embodiments of the present disclosure should not be limited thereto or thereby. According to some embodiments, the length in the first direction DRT1 of the pulsating heat pipes PHPs may be 300 mm (or about 300 mm) or 450 mm (or about 450mm).

Referring to FIG. 12B, the pulsating heat pipes PHPs may be arranged in the first direction DRT1. In addition, when the pulsating heat pipes PHPs are classified into a first-first group PHPa1 to PHPan arranged in the first direction DRT1 and a first-second group PHPb1 to PHPbn arranged in the first direction DRT1, the first-first group PHPa1 to PHPan and the first-second group PHPb1 to PHPbn may be arranged in the second direction DRT2.

Among the pulsating heat pipes PHPs, a length in the first direction DRT1 of one pulsating heat pipe PHPs may be 720 mm (or about 720 mm), and a length in the second direction DRT2 of one pulsating heat pipe PHPs may be 162 mm (or about 162 mm). In addition, a length in the first direction DRT1 or in second direction DRT2 of the pulsating heat pipe PHP of the first-first group PHPa1 to PHPan and a length in the first direction DRT1 or in second direction DRT2 of the pulsating heat pipe PHP of the first-second group PHPb1 to PHPbn may be different from each other. As an example, when the pulsating heat pipes PHPs of the first-first group PHPa1 to PHPan have the above lengths in the first and second directions DRT1 and DRT2, the length in the first direction DRT1 of the pulsating heat pipe PHP of the first-second group PHPb1 to PHPbn may be 800 mm (or about 800 mm), and the length in the second direction DRT2 of the pulsating heat pipe PHP of the first-second group PHPb1 to PHPbn may be 270 mm (or about 270 mm) or 405 mm (or about 405 mm).

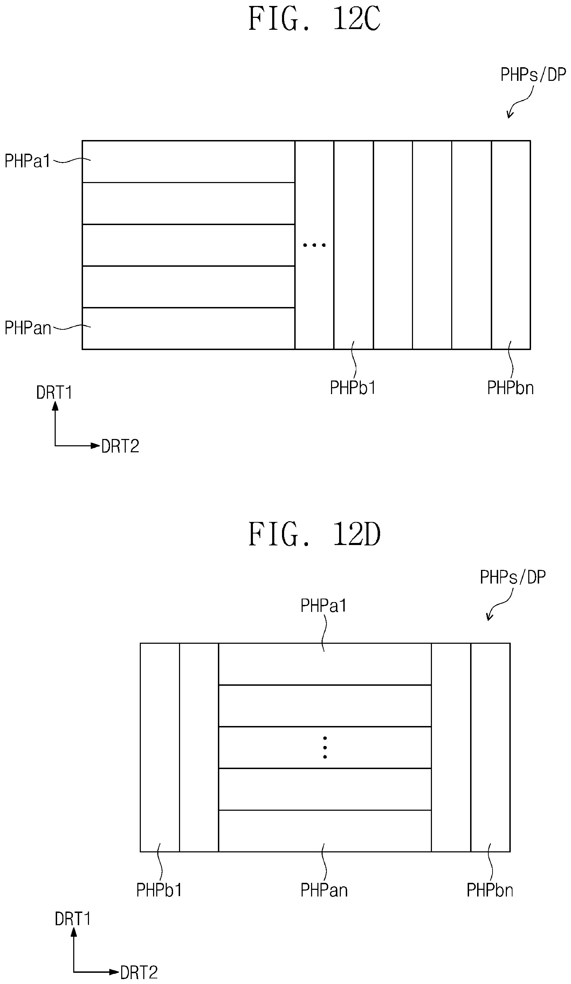

Referring to FIGS. 12C and 12D, some of the pulsating heat pipes PHPs may be arranged in the first direction DRT1, and the others of the pulsating heat pipes PHPs may be arranged in the second direction DRT2. In this case, when the pulsating heat pipes PHPs arranged in the first direction DRT1 are defined as a first group PHPa1 to PHPan and the pulsating heat pipes PHPs arranged in the second direction DRT2 are defined as a second group PHPb1 to PHPbn, the first group PHPa1 to PHPan and the second group PHPb1 to PHPbn may be arranged in the second direction DRT2.

Referring to FIG. 12D, the first group PHPa1 to PHPan may be provided in plural. The second group PHPb1 to PHPbn may be located between the first groups PHPa1 to PHPan.

According to some embodiments, the second group PHPb1 to PHPbn may be provided in plural, and the first groups PHPa1 to PHPan and the second groups PHPb1 to PHPbn may be alternately arranged with each other in the second direction DRT2, but embodiments of the present disclosure should not be limited thereto or thereby.

A length in the first direction DRT1 or in the second direction DRT2 of the pulsating heat pipes PHPs of the first group PHPa1 to PHPan and a length in the first direction DRT1 or in the second direction DRT2 of the pulsating heat pipes PHPs of the second group PHPb1 to PHPbn may be different from each other. As an example, when the length in the first direction DRT1 of the pulsating heat pipe PHP of the first group PHPa1 to PHPan is 150 (or about 150 mm) or 180 mm (or about 180 mm) and the length in the second direction DRT2 of the pulsating heat pipe PHP of the first group PHPa1 to PHPan is 800 mm (or about 800 mm), the length in the first direction DRT1 of the pulsating heat pipe PHP of the second group PHPb1 to PHPbn may be 720 mm (or about 720 mm), and the length in the second direction DRT2 of the pulsating heat pipe PHP of the first group PHPb1 to PHPbn may be 162 mm (or about 162 mm) or 405 mm (or about 405 mm).

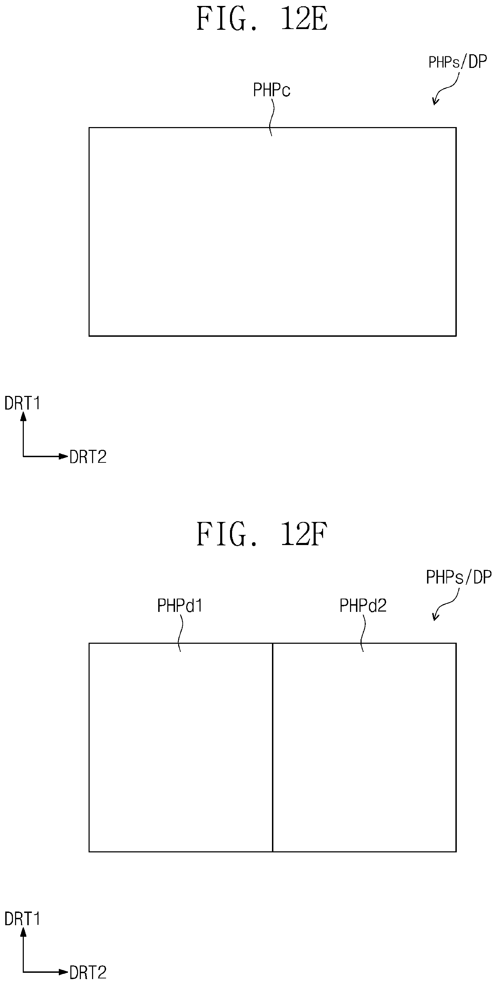

Referring to FIG. 12E, one pulsating heat pipe PHPc may be provided to correspond to the size of the display panel DP. In this case, a length in the first direction DRT1 of the pulsating heat pipe PHPc may be equal to or greater than 1400 mm (or about 1400 mm), and a length in the second direction DRT2 of the pulsating heat pipe PHPc may be equal to or greater than 800 mm (or about 800 mm).

Referring to FIG. 12F, two pulsating heat pipes PHPd1 and PHPd2 may be provided to correspond to the size of the display panel DP. In this case, a length in the first direction DRT1 of one pulsating heat pipe PHPd1 or PHPd2 may be equal to or greater than 800 mm (or about 800 mm), and a length in the second direction DRT2 of one pulsating heat pipe PHPd1 or PHPd2 may be equal to or greater than 700 mm (or about 700 mm).

FIG. 12F shows only two pulsating heat pipes, e.g., a first pulsating heat pipe PHPd1 and a second pulsating heat pipe PHPd2, however, embodiments of the present disclosure should not be limited thereto or thereby. According to some embodiments, the plural pulsating heat pipes may be located at a position where the first pulsating heat pipe PHPd1 or the second pulsating heat pipe PHPd2 is located.

Although aspects of some embodiments of the present disclosure have been described, it is understood that embodiments according to the present disclosure should not be limited to these disclosed embodiments but various changes and modifications can be made by one ordinary skilled in the art within the scope of the present disclosure as hereinafter claimed. Therefore, the disclosed subject matter should not be limited to any single embodiment described herein, and the scope of embodiments according to the present disclosure shall be determined according to the appended claims, and their equivalents.

## Claims

1. A display device comprising:
a display module comprising a lower surface defined by a first direction and a second direction intersecting the first direction and an upper surface opposite to the lower surface and configured to display an image; and
a pulsating heat pipe on the lower surface of the display module, the pulsating heat pipe comprising:
a first heat exchanger comprising a plurality of first pipes arranged in the first direction, a plurality of second pipes connecting the first pipes most adjacent to each other among the first pipes, and a first fluid filled in the first pipes and the second pipes and existing in a liquid state or a gaseous state; and
a second heat exchanger spaced apart from the first heat exchanger in the second direction and comprising a plurality of third pipes arranged in the first direction, a plurality of fourth pipes connecting the third pipes most adjacent to each other among the third pipes, and a second fluid filled in the third pipes and the fourth pipes and existing in a liquid state or a gaseous state, wherein each of the first and second heat exchangers comprises a first area, a second area, and a third area, which have different temperatures from each other;
wherein a first ratio, which is defined as a ratio of the first fluid in the gaseous state to the first fluid in the liquid state, is different in each of the first, second, and third areas of the first heat exchanger, and a second ratio, which is defined as a ratio of the second fluid in the gaseous state to the second fluid in the liquid state, is different in each of the first, second, and third areas of the second heat exchanger.

2. The display device of claim 1, wherein the first pipes are linearly symmetrical with the third pipes based on the first direction.

3. The display device of claim 1 or 2, wherein the pulsating heat pipe further comprises a third heat exchanger between the first heat exchanger and the second heat exchanger, and the third heat exchanger comprises a plurality of fifth pipes arranged in the first direction and a plurality of sixth pipes connecting the fifth pipes most adjacent to each other among the fifth pipes;
optionally wherein the pulsating heat pipe further comprises a connection pipe that connects pipes of two heat exchangers among the first, second, and third heat exchangers.

4. The display device of any one of claims 1 to 3, wherein a length in the second direction of the first heat exchanger is greater than 0% and equal to or smaller than 20% of a total length in the second direction of the pulsating heat pipe, and a length in the second direction of the second heat exchanger is greater than 0% and equal to or smaller than 20% of the total length in the second direction of the pulsating heat pipe.

5. The display device of any one of claims 1 to 4, wherein a number of the first pipes is at least five.

6. The display device of any one of claims 1 to 5, wherein a length in the second direction of the pulsating heat pipe is equal to or greater than 400 mm, and a length in the first direction of the pulsating heat pipe is equal to or greater than 100 mm; and/or
wherein a filling rate of the first fluid in the first heat exchanger is equal to or greater than 35% and equal to or smaller than 80%.

7. The display device of any one of claims 1 to 6, wherein the first fluid and the second fluid comprise a same material.

8. The display device of any one of claims 1 to 7, wherein the first area is spaced apart from the third area with the second area interposed therebetween, the third area is insulated, the second area has a temperature greater than a temperature of the first area, and the third area has a temperature lower than the temperature of the second area;
optionally wherein the first ratio is equal to the second ratio in the first area, the first ratio is equal to the second ratio in the second area, and the first ratio is equal to the second ratio in the third area.

9. The display device of any one of claims 1 to 8, wherein the first heat exchanger further comprises a plurality of check valves in the first pipes between the second area and the third area;
optionally wherein the plurality of check valves comprises: a first portion comprising a first sub-portion extending in the second direction and a second sub-portion bent from the first sub-portion and inclined at a first angle with respect to the second direction; and a second portion comprising a third sub-portion bent from the second sub-portion and inclined at a second angle greater than the first angle with respect to the first direction and a fourth sub-portion bent from the third sub-portion and extending in the second direction;
optionally wherein the second portion further comprises at least a one flow control member spaced apart from the third sub-portion by a predetermined distance, and the flow control member overlaps the third sub-portion when viewed in the second direction;
optionally wherein the first angle is 25 degrees, and the second angle is 60 degrees.

10. The display device of any one of claims 1 to 9, wherein the pulsating heat pipe is provided in plural, and the pulsating heat pipes are arranged in the first direction or the second direction; or
wherein the pulsating heat pipe is provided in plural, some pulsating heat pipes among the pulsating heat pipes are arranged in the first direction, and the other pulsating heat pipes among the pulsating heat pipes are arranged in the second direction.

11. The display device of any one of claims 1 to 10, wherein the first pipes have a polygonal shape when viewed in a cross-section defined by the first direction and a third direction intersecting the second direction.

12. The display device of any one of claims 1 to 11, wherein the pulsating heat pipe further comprises:
a first plate comprising a first surface defined by the first direction and the second direction and a second surface opposite to the first surface; and
a second plate on the first surface, and the first plate is recessed in a third direction intersecting the second direction and defined by a recessed portion extending in the third direction.

13. A display device comprising:
a display module comprising a lower surface defined by a first direction and a second direction intersecting the first direction and an upper surface opposite to the lower surface and displaying an image; and
a heat pipe on the lower surface of the display module, the heat pipe comprising:
a first heat exchanger comprising a plurality of first pipes arranged in the first direction, a plurality of second pipes connecting the first pipes most adjacent to each other among the first pipes, and a first fluid filled in the first pipes and the second pipes and existing in a liquid state or a gaseous state; and
a second heat exchanger spaced apart from the first heat exchanger in the second direction and comprising a plurality of third pipes arranged in the first direction, a plurality of fourth pipes connecting the third pipes most adjacent to each other among the third pipes, and a second fluid filled in the third pipes and the fourth pipes and existing in a liquid state or a gaseous state, wherein the first heat exchanger and the second heat exchanger are symmetrical with each other.

14. The display device of claim 13, wherein the heat pipe is provided with a pulsating heat pipe, each of the first and second heat exchangers comprises a first area, a second area adjacent to the first area, and a second area spaced apart from the first area with the third area interposed therebetween, the third area is insulated, the second area has a temperature greater than a temperature of the first area, and the third area has a temperature lower than the temperature of the second area;
optionally wherein the first heat exchanger further comprises a plurality of check valves in the first pipes between the second area and the third area;
optionally wherein the plurality of the check valves comprises: a first portion comprising a first sub-portion extending in the second direction and a second sub-portion bent from the first sub-portion and inclined at a first angle with respect to the second direction; and a second portion comprising a third sub-portion bent from the second sub-portion and inclined at a second angle greater than the first angle with respect to the first direction and a fourth sub-portion bent from the third sub-portion and extending in the second direction;
optionally wherein the second portion further comprises at least a one flow control member spaced apart from the third sub-portion with a predetermined distance, and the flow control member overlaps the third sub-portion when viewed in the second direction.

15. The display device of claim 13 or 14, wherein the heat pipe further comprises:
a first plate comprising a first surface defined by the first direction and the second direction and a second surface opposite to the first surface; and
a second plate on the first surface, and the first plate is recessed in a third direction intersecting the second direction and defined by a recessed portion extending in the third direction.
